# EUROPEAN PATENT APPLICATION

(11) **EP 1 549 112 A1**
(43) Date of publication of application: **29.06.2005**
(21) Application number: 03797660.2
(22) Date of filing: 18.09.2003
(51) Int. Cl.: H05B 33/22, H05B 33/14

(54) **ORGANIC ELECTROLUMINESCENT ELEMENT**

(30) Priority: 20.09.2002 JP 2002275083
(71) Applicant: IDEMITSU KOSAN CO., LTD., Tokyo 100-8321 (JP)
(72) Inventor: ARAKANE, Takashi, Sodegaura-shi, Chiba 299-0205 (JP); IWAKUMA, Toshihiro, Sodegaura-shi, Chiba 299-0205 (JP); HOSOKAWA, Chishio, Sodegaura-shi, Chiba 299-0205 (JP)
(74) Representative: Gille Hrabal Struck Neidlein Prop Roos
(86) International application number: PCT/JP2003/011898
(87) International publication number: WO 2004/028217

(57) **Abstract**

An organic electroluminescence device comprising a cathode, an anode and an organic thin film layer which is sandwiched between the cathode and the anode and comprises at least one layer containing a light emitting layer comprising a phosphorescent light emitting compound is provided. The device comprises an electron injecting layer which is adhered to the cathode and comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as the main component and at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds as the reductive dopant. The device uses phosphorescent light emission, exhibits a great efficiency of light emission and has a long life.

## Description

### TECHNICAL FIELD

The present invention relates to an organic electroluminescent element (an electroluminescent element will be referred to as an electroluminescence device, hereinafter) and, more particularly, to an electroluminescence device which utilizes phosphorescent light emission, exhibits a great efficiency of light emission and has a long life.

### BACKGROUND ART

An organic electroluminescence ("electroluminescence" will be occasionally referred to as "EL", hereinafter) device is a spontaneous light emitting device which utilizes the principle that a fluorescent substance emits light by energy of recombination of holes injected from an anode and electrons injected from a cathode when an electric field is applied. Since an organic EL device of the laminate type driven under a low electric voltage was reported by C. W. Tang of Eastman Kodak Company (C. W. Tang and S. A. Vanslyke, Applied Physics Letters, Volume 51, Pages 913, 1987), many studies have been conducted on organic EL devices using organic materials as the constituting materials. Tang et al. used a laminate structure using tris(8-hydroxyquinolinol)aluminum for the light emitting layer and a triphenyldiamine derivative for the hole transporting layer. Advantages of the laminate structure are that the efficiency of hole injection into the light emitting layer can be increased, that the efficiency of forming excited particles which are formed by blocking and recombining electrons injected from the cathode can be increased, and that excited particles formed among the light emitting layer can be enclosed. As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.

As the light emitting material of the organic EL device, chelate complexes such as tris(8-quinolinolato)aluminum, coumarine derivatives, tetraphenylbutadiene derivatives, bisstyrylarylene derivatives and oxadiazole derivatives are known. It is reported that light in the visible region ranging from blue light to red light can be obtained by using these light emitting materials, and development of a device exhibiting color images is expected (For example, Japanese Patent Application Laid-Open Nos. Heisei 8(1996)-239655 and Heisei 7(1995)-138561).

It is recently proposed that an organic phosphorescent materials is used in the light emitting layer of an organic EL device in combination with a light emitting material (for example, D. F. O'Brien, M. A. Baldo et al., "Improved energy transfer in electrophosphorescent devices", Applied Physics Letters, Vol. 74, No. 3, Pages 442 to 444, January 18, 1999; and M. A. Baldo et al., "Very high-efficiency green organic light-emitting devices based on electrophosphorescence", Applied Physics Letters, Vol. 75, No. 1, Pages 4 to 6, July 5, 1999).

As described above, a great efficiency of light emission is achieved by utilizing an organic phosphorescent material excited to the singlet state and the triplet state in the light emitting layer of an organic EL device. It is considered that singlet excimers and triplet excimers are formed in relative amounts of 1:3 due to the difference in the multiplicity of spin when electrons and holes are recombined in an organic EL device. Therefore, it is expected that an efficiency of light emission 3 to 4 times as great as that of a device utilizing fluorescence alone can be achieved by utilizing a phosphorescent light emitting material.

In the organic EL devices such as those described above, constructions in which layers such as an anode, an organic light emitting layer, an electron transporting layer (a hole barrier layer), an electron injecting layer and a cathode are successively laminated are used so that light emission in the condition excited to the triplet state or from excimers in the triplet state is not quenched. When a hole barrier layer which restricts transfer of holes from the organic light emitting layer is sandwiched between the organic light emitting layer and the cathode and holes are efficiently accumulated in the light emitting layer, the probability of recombination of holes with electrons can be increased, and an increase in the efficiency of light emission can be achieved. However, it has been recognized that an electron injecting layer might be disposed between the hole barrier layer and the cathode metal since the properties such as the life and the efficiency markedly deteriorate when the hole barrier layer and the cathode metal are directly adhered to each other (for example, the United States Patent No. 6097147, and International Patent Application Published under PCT No. WO01/41512).

However, conventional constructions for electron injection have a drawback in that phenanthroline derivatives used for the electron transporting layer tend to be degraded although an excellent hole barrier property can be exhibited, and no devices having a long life can be obtained. Japanese Patent Application Laid-Open No. 2001-284056 discloses a technology for increasing the life in which a metal complex-based material (a BMq-based material) having 8-hydroxyquinoline coordinated at two positions in place of the phenanthroline derivative and an aryloxyl compound coordinated at the remaining positions is used for the hole barrier layer. However, the construction formed by successively laminating layers such as an organic light emitting layer, an electron transporting layer (a hole barrier layer), an electron injecting layer and a cathode is used, and it is desired that the layer construction is more simplified.

As the result of studies by the present inventors on the above construction for electron injection, it was concluded that Mg-based alloys and lithium oxide conventionally used as the material of the cathode could not provide the sufficient properties such as the efficiency and the life even when the hole barrier layer and the cathode were adhered to each other since the close adherence of these materials with BMq-based materials described above was insufficient, and it was newly recognized that an improvement in the close adherence between the cathode and BMq is necessary to simplify the layer construction.

Compounds having a condensed six-membered ring having nitrogen atom such as phenanthroline derivatives as the typical examples have highly planer molecular structures, and the light emission from the triplet state at the interface of the light emitting layer tends to be quenched. When any of five-membered cyclic derivatives having nitrogen atom, non-condensed six-membered cyclic derivatives having nitrogen atom and condensed six-membered cyclic derivatives having nitrogen atom and one condensed carbon ring is used to overcome the above drawback, a problem arises in that the life of the organic EL device is short. When the cyclic derivative having nitrogen atom is used singly for the transport of electrons, the ability of transporting electrons is insufficient. Therefore, the ability of transporting electrons tends to be degraded, and degradation takes place when holes are injected into the electron injecting layer.

### DISCLOSURE OF THE INVENTION

The present invention has an object of overcoming the above problems and providing an organic EL device utilizing phosphorescent light emission which exhibits a great efficiency of light emission and has a long life.

As the result of intensive researches and studies to achieve the above object by the present inventors, it was found that close adherence between the cathode and the electron injecting layer was improved, the electron transporting ability of the electron injecting layer could be improved, and the degradation caused by injection of holes could be suppressed when the cathode and the electron injecting layer were closely adhered to each other, and the electron injecting layer comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as the main component and a specific reductive dopant and, therefore, an organic EL device utilizing phosphorescent light emission which exhibits a great efficiency of light emission and has a long life could be provided. The present invention has been completed based on this knowledge.

The present invention provides an organic EL device comprising a cathode, an anode and an organic thin film layer which is sandwiched between the cathode and the anode and comprises at least one layer containing a light emitting layer comprising a phosphorescent light emitting compound, wherein the organic electroluminescence device further comprises an electron injecting layer which is adhered to the cathode and comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as a main component and at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds as a reductive dopant.

The term "main component" in the description is defined as the component occupying in excess of 50 % by weight.

### THE MOST PREFERRED EMBODIMENT TO CARRY OUT THE INVENTION

The organic EL device comprises a cathode, an anode and an organic thin film layer which is sandwiched between the cathode and the anode and comprises at least one layer containing a light emitting layer comprising a phosphorescent light emitting compound, wherein the organic electroluminescence device further comprises an electron injecting layer which is adhered to the cathode and comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as the main component and at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds as the reductive dopant.

It is preferable that the metal chelate complex with a ring having nitrogen atom, which is the main component of the electron injecting layer as described above, is a compound represented by the following general formula (1):

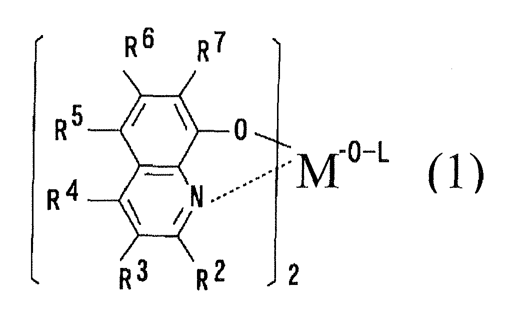

In general formula (1), R² to R⁷ each independently represent hydrogen atom, a halogen atom, an oxy group, an amino group or a hydrocarbon group having 1 to 40 carbon atoms, each of which may be substituted.

Examples of the halogen atom represented by R² to R⁷ in general formula (1) include fluorine atom, chlorine atom, bromine atom and iodine atom.

The amino group represented by R² to R⁷ in general formula (1), which may be substituted, is a group represented by -NX¹X². Examples of the atom and the group which X¹ and X² each independently represent include hydrogen atom, methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy- isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3- tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 4-styrylphenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin- 10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methyl-pyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the hydrocarbon group having 1 to 40 carbon atoms which is represented by R² to R⁷ in general formula (1) include alkyl groups, alkenyl groups, cycloalkyl groups, alkoxyl groups, aromatic hydrocarbon groups, aromatic heterocyclic groups, aralkyl groups, aryloxyl groups and alkoxycarbonyl groups, which are each substituted or unsubstituted.

Examples of the substituted or unsubstituted alkyl group described above include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triamino-propyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the substituted or unsubstituted alkenyl group described above include vinyl group, allyl group, 1-butenyl group, 2-butenyl group, 3-butenyl group, 1,3-butadienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group and 3-phenyl-1-butenyl group.

Examples of the substituted or unsubstituted cycloalkyl group described above include cyclopropyl group, cyclobutyl group, cyclopentyl group, cyclohexyl group and 4-methylcyclohexyl group.

The substituted or unsubstituted alkoxyl group described above is represented by -OY¹. Examples of the group represented by Y¹ include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the substituted or unsubstituted aromatic hydrocarbon group described above include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group and 4"-t-butyl-p-terphenyl-4-yl group.

Examples of the substituted or unsubstituted aromatic heterocyclic group described above include 1-pyrrolyl group, 2-pyrrolyl group, 3-pyrrolyl group, pyradinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the substituted or unsubstituted aralkyl group described above include benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group and 1-chloro-2-phenylisopropyl group.

The substituted or unsubstituted aryloxyl group described above is represented by -OZ. Examples of the group represented by Z include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butylp-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

The substituted or unsubstituted alkoxycarbonyl group described above is represented by -COOY². Examples of the group represented by Y² include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the substituent to the groups represented by R² to R⁷ in general formula (1) include alkyl group, alkenyl group, alkynyl group, aromatic hydrocarbon group, amino group, alkoxyl group, aryloxyl group, acyl group, alkoxycarbonyl group, aryloxycarbonyl group, acyloxyl group, acylamino group, alkoxycarbonylamino group, aryloxycarbonylamino group, sulfonylamino group, sulfamoyl group, carbamoyl group, alkylthio group, arylthio group, sulfonyl group, halogen atom, cyano group and aromatic heterocyclic group.

As the substituent to the groups represented by R² to R⁷ in general formula (1), cyano group, halogen atom, haloalkyl group having 10 or less carbon atoms, haloalkoxyl group, amino group, carbonyl group, carbonyloxyl group and oxycarbonyl group are preferable.

In general formula (1), M represents aluminum (Al), gallium (Ga) or indium (In) and preferably represents In.

In general formula (1), L represents a group represented by the following general formula (2) or (3): 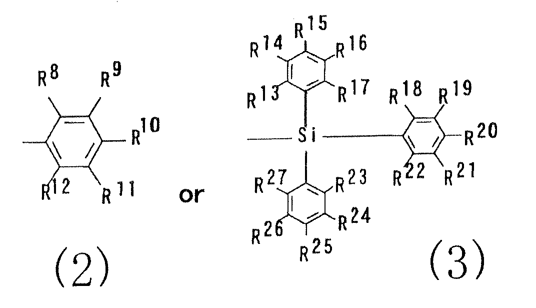 wherein R⁸ to R¹² each independently represent hydrogen atom or a substituted or unsubstituted hydrocarbon group having 1 to 40 carbon atoms, adjacent groups represented by R⁸ to R¹² may be bonded to each other to form a cyclic structure, R¹³ to R²⁷ each independently represent hydrogen atom or a substituted or unsubstituted hydrocarbon group having 1 to 40 carbon atoms, and adjacent groups represented by R¹³ to R²⁷ may be bonded to each other to form a cyclic structure.

Examples of the hydrocarbon group having 1 to 40 carbon atoms which is represented by R⁸ to R¹² and R¹³ to R²⁷ each in general formulae (2) and (3) respectively include the groups described above as the specific examples of the group represented by R² to R⁷.

Examples of the divalent group in the cyclic structure formed by the bonding of the adjacent groups represented by R⁸ to R¹² and R¹³ to R²⁷ include tetramethylene group, pentamethylene group, hexamethylene group, diphenylmethan-2,2'-diyl group, diphenylethan-3,3'-diyl group and diphenylpropan-4,4'-yl group.

Specific examples of the metal chelate complex with a ring having nitrogen atom which is represented by general formula (1) are shown in the following. However, the metal chelate complex is not limited to the compounds shown as the examples.

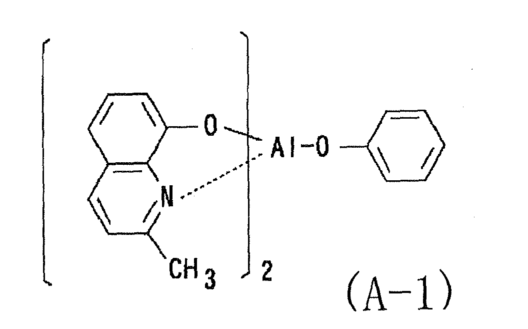

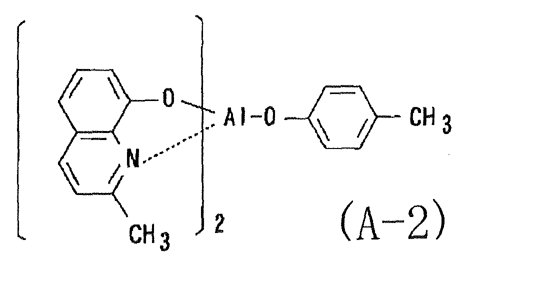

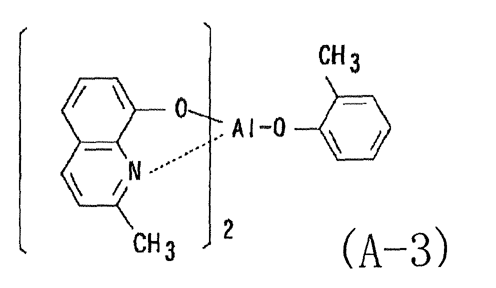

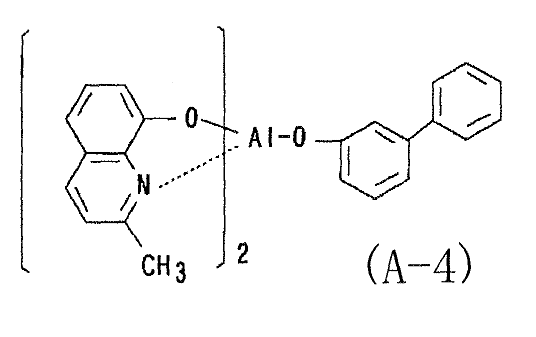

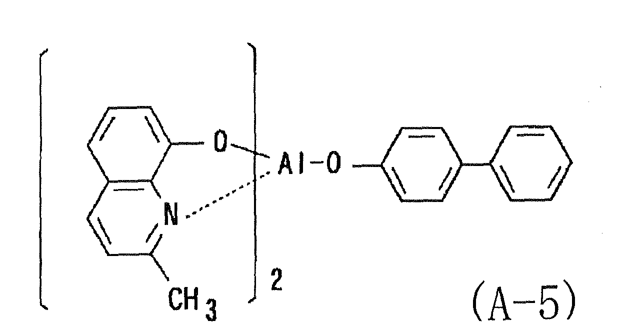

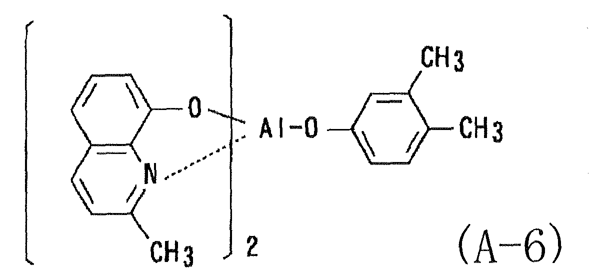

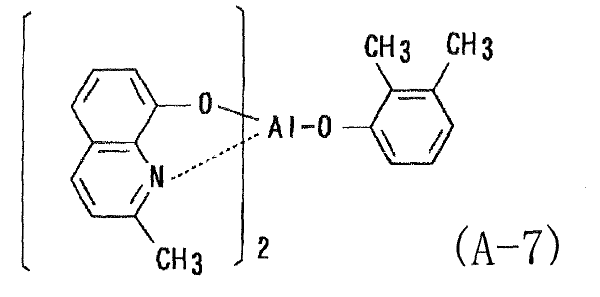

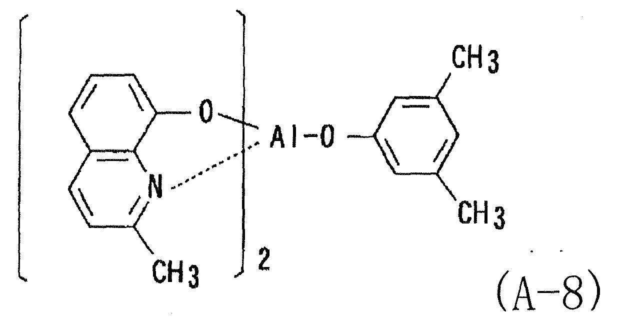

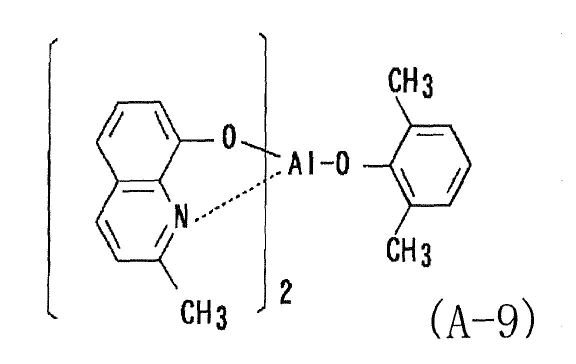

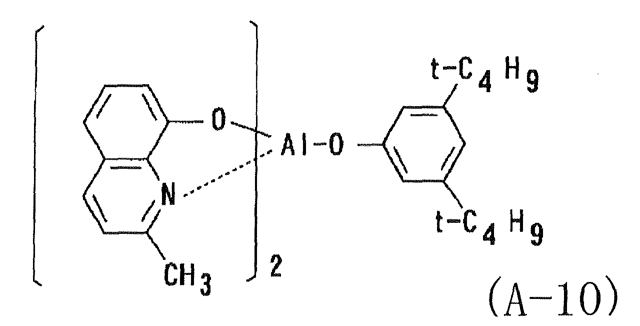

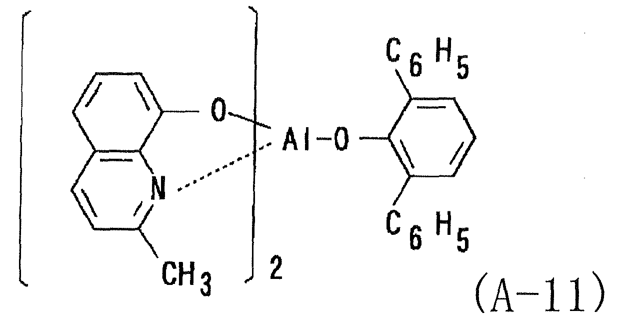

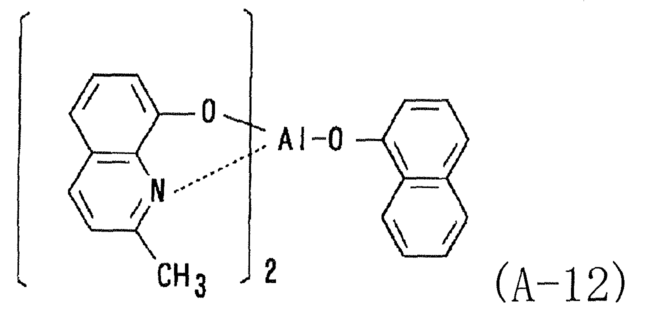

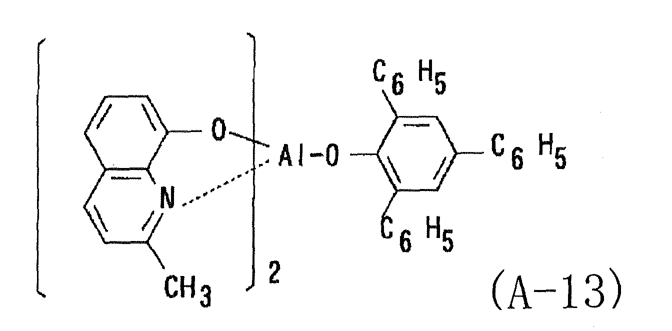

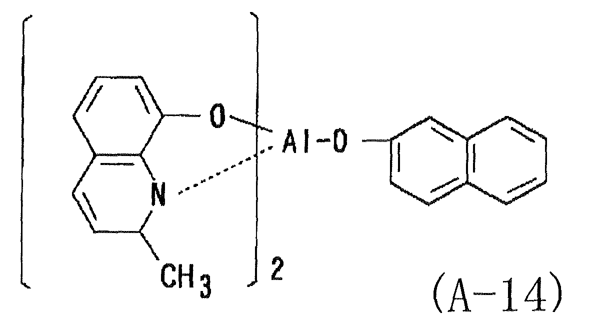

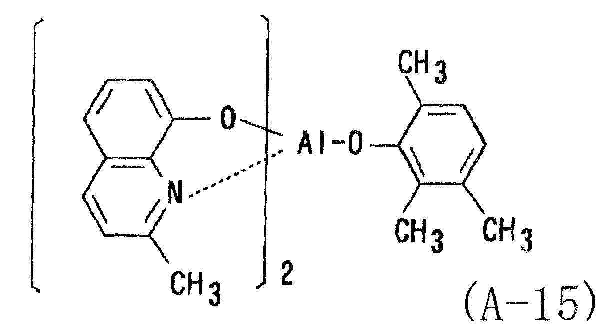

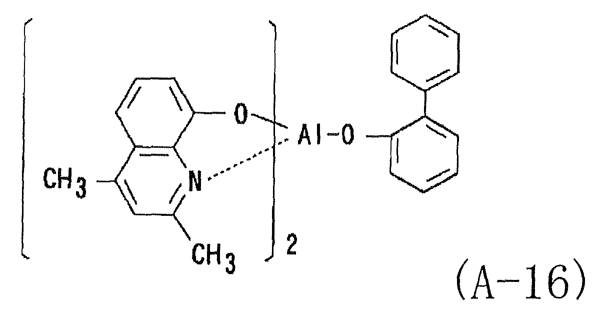

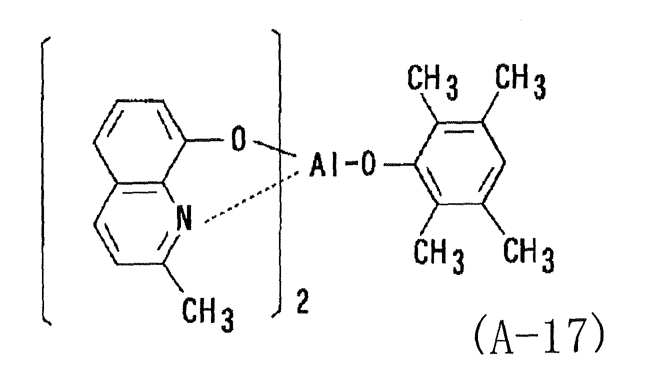

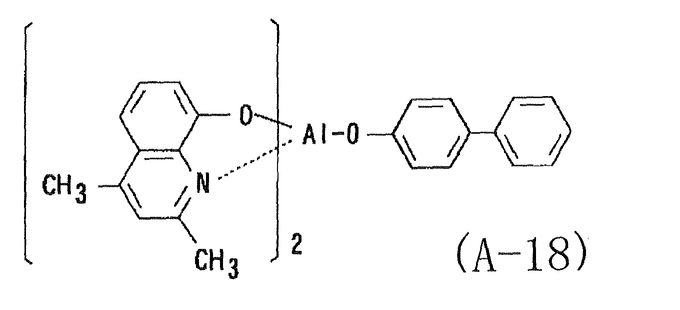

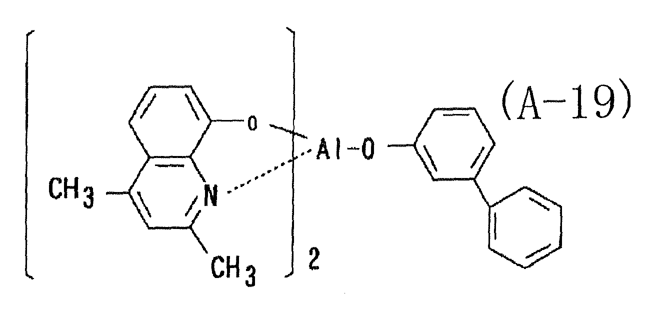

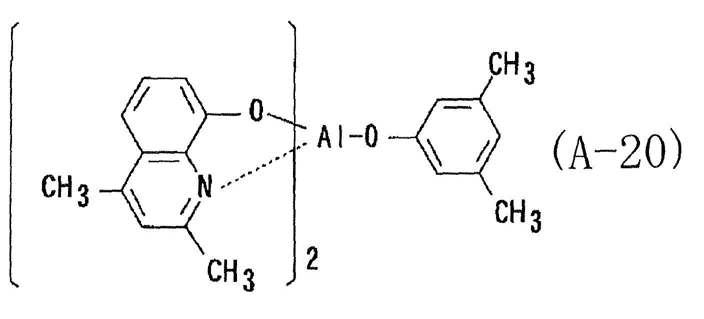

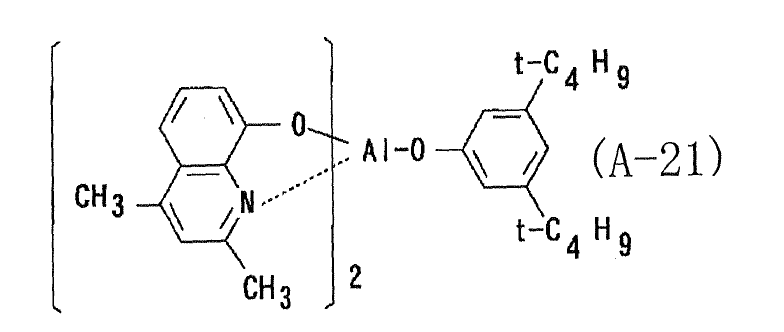

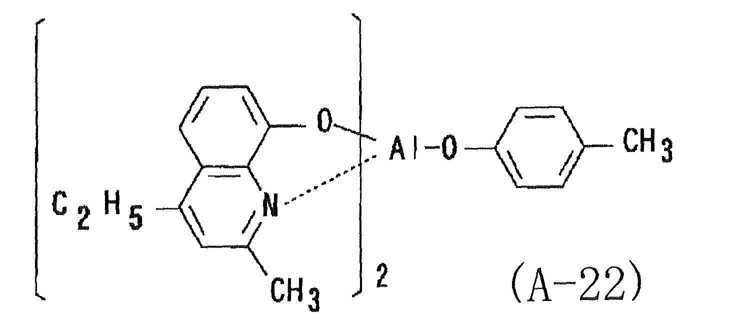

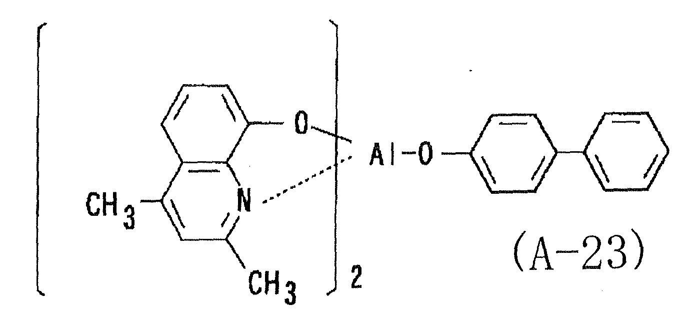

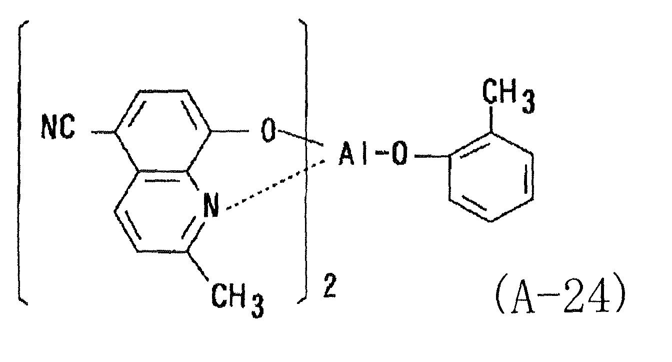

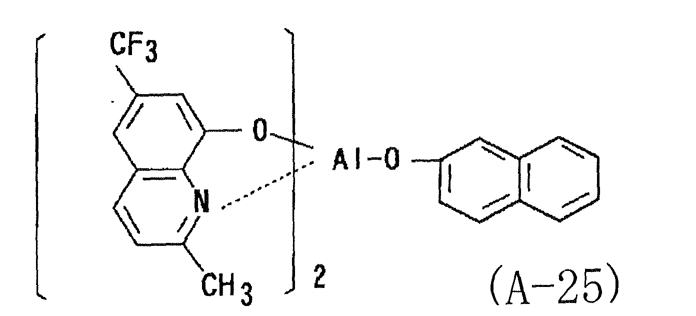

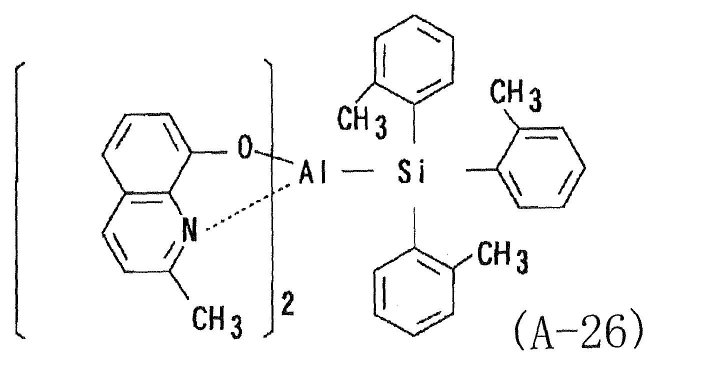

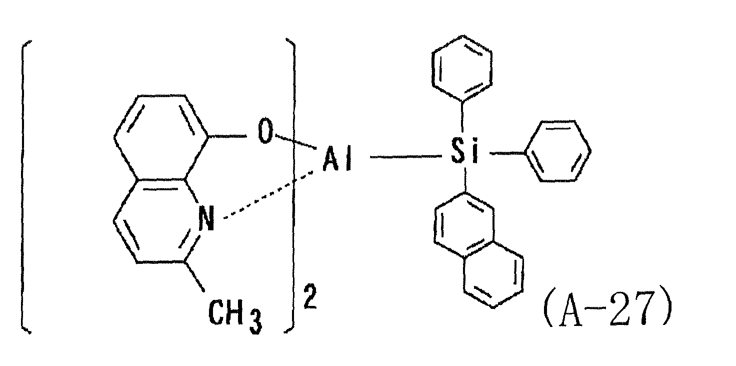

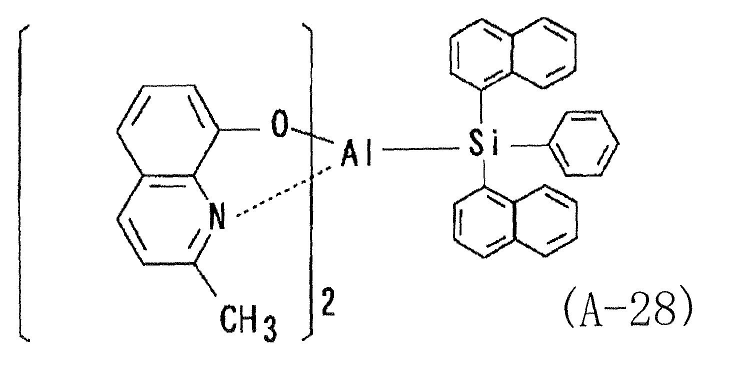

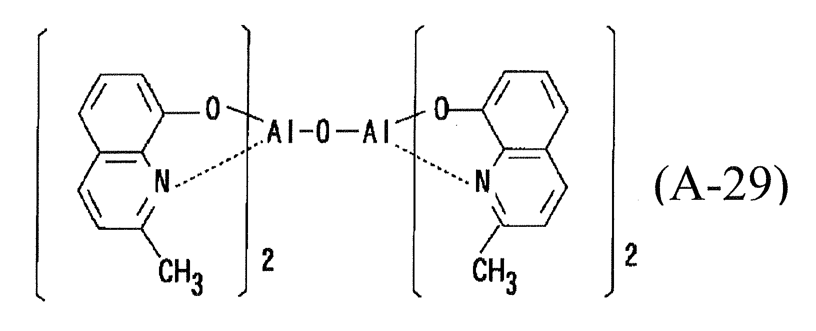

In the five-membered cyclic derivative having nitrogen atom which is the main component of the electron injecting layer described above, examples of the five-membered ring include imidazole ring, triazole ring, tetrazole ring, thiadiazole ring, oxatriazole ring and thiatriazole ring. Examples of the five-membered cyclic derivative having nitrogen atom include benzimidazole ring, pyrimidinoimidazole ring, pyridinoimidazole ring and pyridazinoimidazole ring.

It is preferable that the five-membered cyclic derivative having nitrogen atom is a compound represented by the following general formula (B): 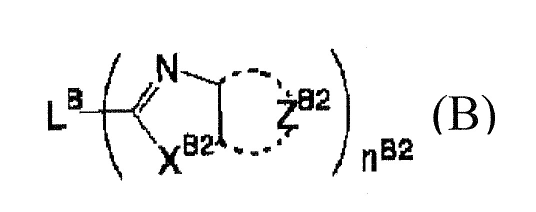 or the following general formula (C):

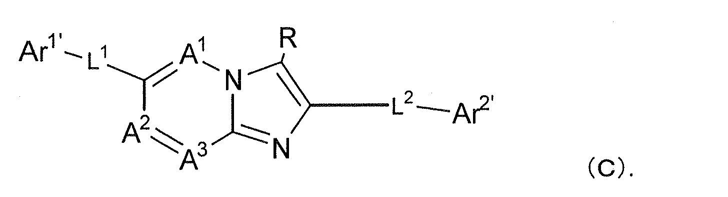

In general formula (B), L^{B} represents a monovalent group or a linking group having a functionality of two or greater, examples of which include carbon atom, silicon atom, nitrogen atom, boron atom, oxygen atom, sulfur atom, metals such as barium and beryllium, aromatic hydrocarbon groups and aromatic heterocyclic groups. Among these atoms and groups, carbon atom, nitrogen atom, silicon atom, boron atom, oxygen atom, sulfur atom, aromatic hydrocarbon groups and aromatic heterocyclic groups are preferable, and carbon atom, silicon atom, aromatic hydrocarbon groups and aromatic heterocyclic groups are more preferable.

The aromatic hydrocarbon group and the aromatic heterocyclic group represented by L^{B} may have substituents. As the substituent, alkyl groups, alkenyl groups, alkynyl groups, aromatic hydrocarbon groups, amino group, alkoxyl groups, aryloxyl groups, acyl groups, alkoxycarbonyl groups, aryloxycarbonyl groups, acyloxyl groups, acylamino groups, alkoxycarbonylamino groups, aryloxycarbonylamino groups, sulfonylamino groups, sulfamoyl groups, carbamoyl groups, alkylthio groups, alkylthio groups, arylthio groups, sulfonyl group, halogen atoms, cyano group and aromatic heterocyclic groups are preferable. Alkyl groups, aryl groups, alkoxyl groups, aryloxyl groups, halogen atoms, cyano group and aromatic heterocyclic group are more preferable. Alkyl groups, aryl groups, alkoxyl groups, aryloxyl groups and aromatic heterocyclic groups are still more preferable, and alkyl groups, aryl groups, alkoxyl groups and aromatic heterocyclic groups are most preferable.

Specific examples of the group represented by L^{B} include the groups shown in the following.

When the group represented by L^{B} is monovalent, groups represented by -L-Ar¹-Ar² are preferable as the group represented by L^{B}. Examples of the above group are shown in the following. In the following groups, the residue group of the five-membered cyclic derivative having nitrogen atom shown among the parenthesis ( ) in general formula (B) is represented by HAr.

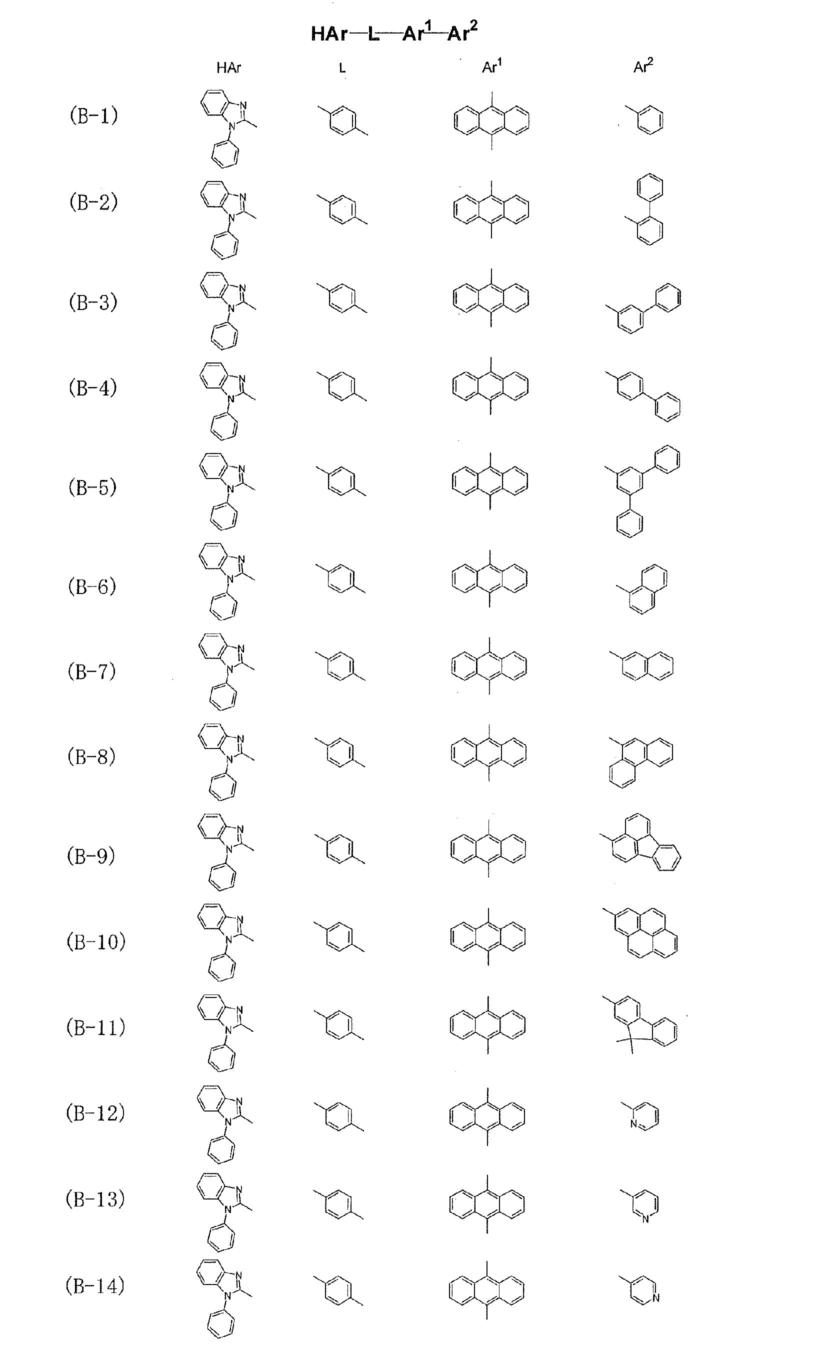

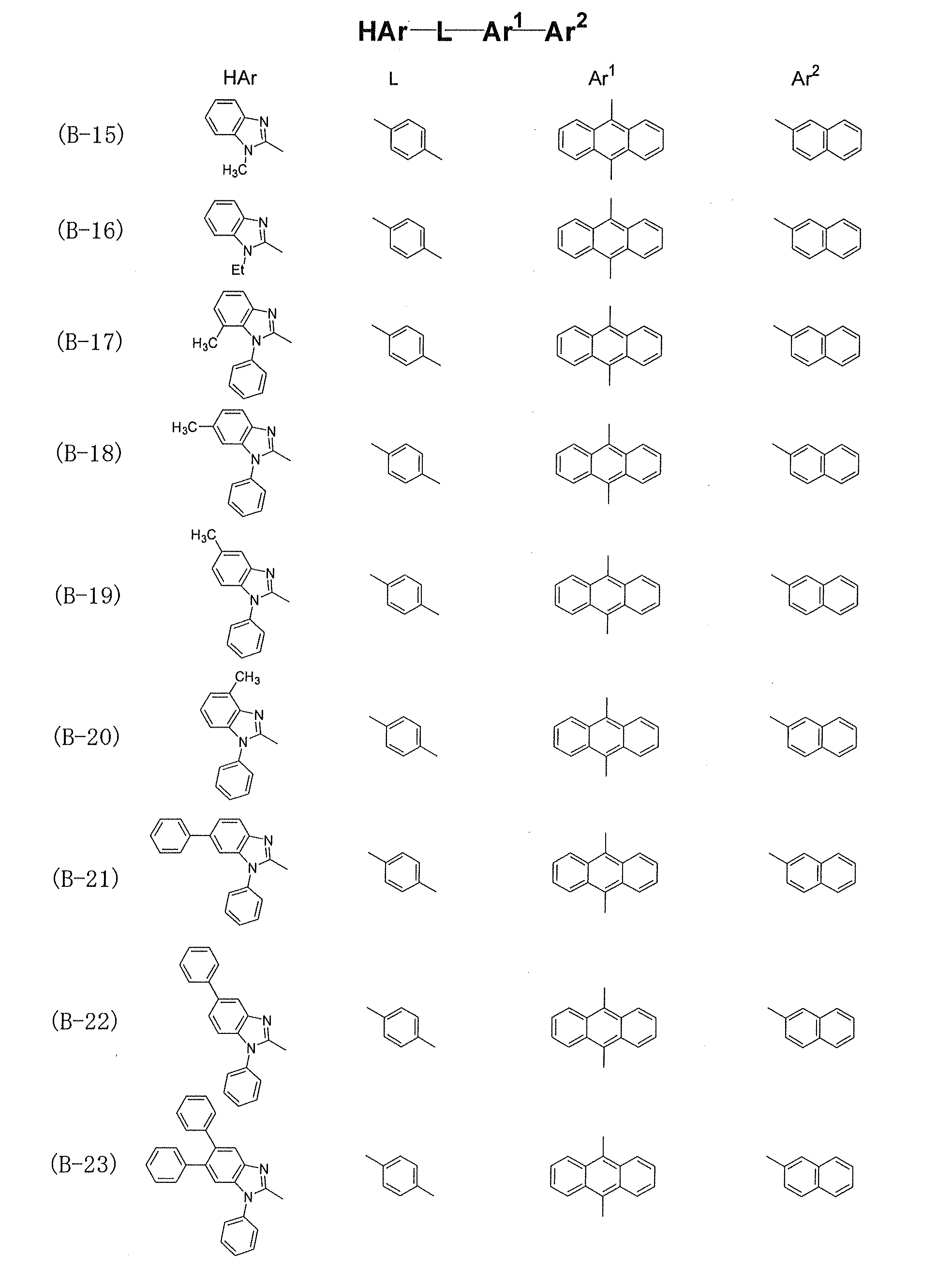

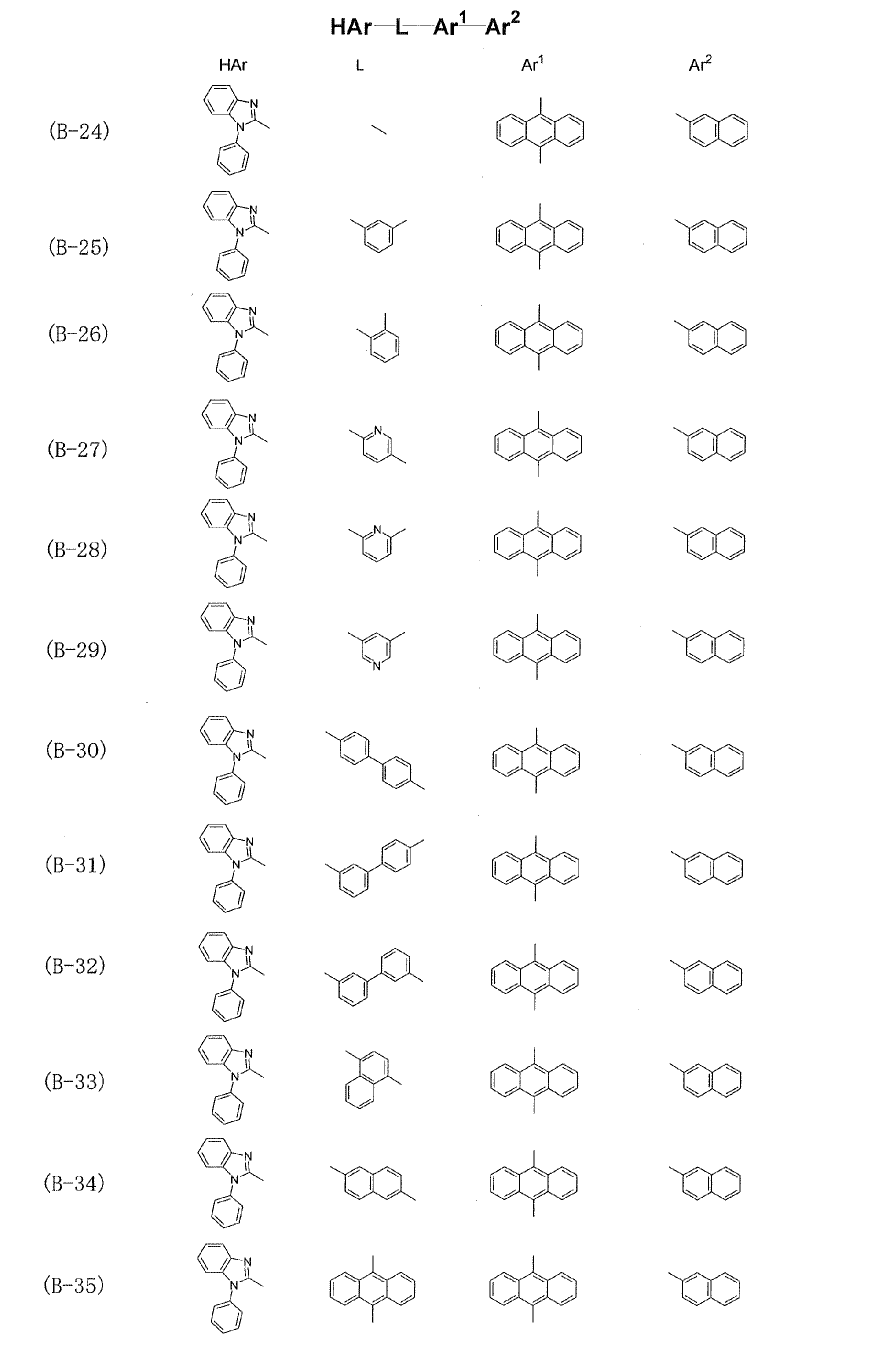

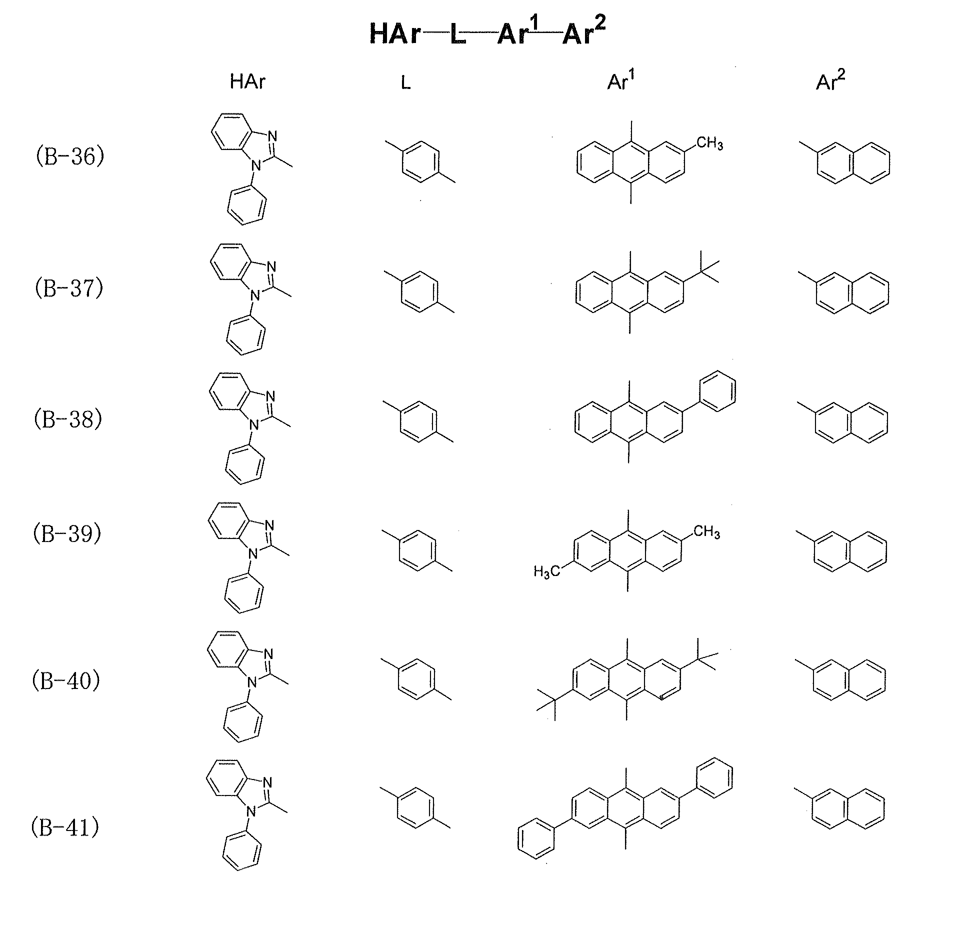

Examples of the group having a functionality of two or greater which is represented by L^{B} are shown in the following.

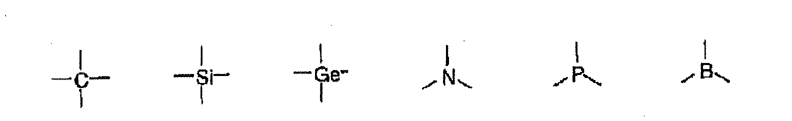

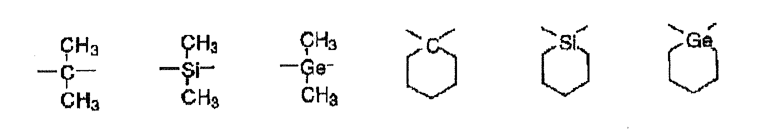

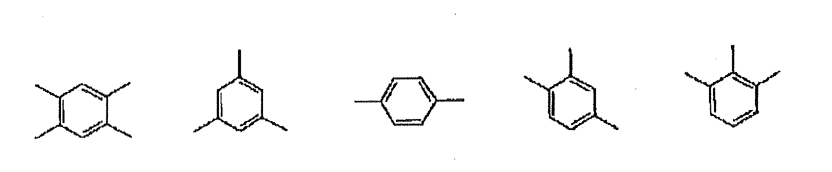

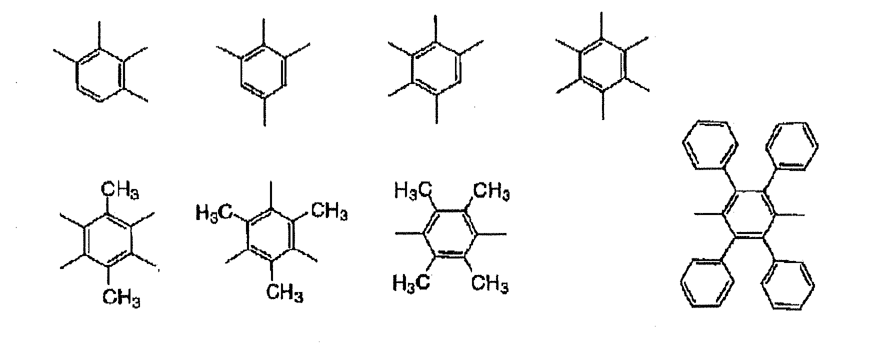

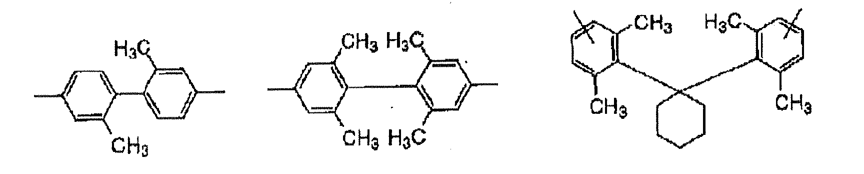

X^{B2} in general formula (B) represents -S- or a group represented by =N-R^{B2}. R^{B2} represents hydrogen atom, an aliphatic hydrocarbon group, an aromatic hydrocarbon group or a heterocyclic group.

The aliphatic hydrocarbon group represented by R^{B2} is a linear, branched or cyclic alkyl group (an alkyl group preferably having 1 to 20 carbon atoms, more preferably having 1 to 12 carbon atoms and most preferably having 1 to 8 carbon atoms, such as methyl group, ethyl group, isopropyl group, tert-butyl group, n-octyl group, n-decyl group, n-hexadecyl group, cyclopropyl group, cyclopentyl group and cyclohexyl group), an alkenyl group (an alkenyl group preferably having 2 to 20 carbon atoms, more preferably having 2 to 12 carbon atoms and most preferably having 2 to 8 carbon atoms, such as vinyl group, allyl group, 2-butenyl group and 3-pentenyl group), or an alkynyl group (an alkynyl group preferably having 2 to 20 carbon atoms, more preferably having 2 to 12 carbon atoms and most preferably having 2 to 8 carbon atoms, such as propargyl group and 3-pentynyl group). An alkyl group is preferable among these groups.

The aromatic hydrocarbon group represented by R^{B2} is a group having a single ring or a condensed ring, which is an aromatic hydrocarbon group preferably having 6 to 30 carbon atoms, more preferably having 6 to 20 carbon atoms and most preferably having 6 to 12 carbon atoms, such as phenyl group, 2-methylphenyl group, 3-methylphenyl group, 4-methylphenyl group, 2-methoxyphenyl group, 3-trifluoromethylphenyl group, pentafluorophenyl group, 1-naphthyl group and 2-naphthyl group.

The heterocyclic group represented by R^{B2} has a single ring or a condensed ring, preferably has 1 to 20 carbon atoms, more preferably having 1 to 12 carbon atoms and most preferably having 2 to 10 carbon atoms and is preferably an aromatic heterocyclic group having at least one of nitrogen atom, oxygen atom, sulfur atom and selenium atom. Examples of the heterocyclic group include groups derived from pyrrolidine, piperidine, piperazine, morpholine, thiophene, selenophene, furan, pyrrol, imidazole, pyrazole, pyridine, pyrazine, pyridazine, pyrimidine, triazole, triazine, indole, indazole, purine, thiazoline, thiazole, thiadiazole, oxazoline, oxazole, oxadiazole, quinoline, isoquinoline, phthalazine, naththylidine, quinoxaline, quinazoline, cinnoline, puteridine, acridine, phenanthroline, phenazine, tetrazole, benzimidazole, benzoxazole, benzothiazole, benzotriazole, tetrazaindene, carbazole and azepine. Groups derived from furan, thiophene, pyridine, pyrazine, pyrimidine, pyridazine, triazine, quinoline, phthalazine, naphthylidine, quinoxaline and quinazoline are preferable, and groups derived from quinoline are more preferable.

The aliphatic hydrocarbon group, the aromatic hydrocarbon group and the heterocyclic group which are represented by R^{B2} may have substituents. Examples of the substituent include the substituents described as the examples of the substituent to the group represented by L^{B}. Preferable examples of the substituent include the substituents described as the preferable examples of the substituent to the group represented by L^{B}.

It is preferable that R^{B2} represents an aliphatic hydrocarbon group, an aromatic hydrocarbon group or a heterocyclic group. It is more preferable that R^{B2} represents an aliphatic hydrocarbon group (preferably having 6 to 30 carbon atoms, more preferably having 6 to 20 carbon atoms and most preferably having 6 to 12 carbon atoms) or an aromatic hydrocarbon. It is most preferable that R^{B2} represents an aliphatic hydrocarbon group (preferably having 1 to 20 carbon atoms, more preferably having 1 to 12 carbon atoms and most preferably having 2 to 10 carbon atoms).

It is preferable that X^{B2} in general formula (B) represents a group represented by =N-R^{B2}.

In general formula (B), Z^{B2} represents a group of atoms necessary for forming an aromatic ring. The aromatic ring formed with the group of atoms represented by Z^{B2} may be any of an aromatic hydrocarbon ring and an aromatic heterocyclic ring. Examples of the aromatic ring include benzene ring, pyridine ring, pyrazine ring, pyrimidine ring, pyridazine ring, triazine ring, pyrrol ring, furan ring, thiophene ring, selenophene ring, tellurophene ring, imidazole ring, thiazole ring, selenazole ring, tellurazole ring, thiadiazole ring, oxadiazole ring and pyrazole ring. Among these rings, benzene ring, pyridine ring, pyrazine ring, pyrimidine ring and pyridazine ring are preferable, and benzene ring, pyridine ring and pyrazine ring are more preferable. Benzene ring and pyridine ring are still more preferable, and pyridine ring is most preferable.

The aromatic ring formed with the group of atoms represented by Z^{B2} may form a condensed ring with another ring and may have substituents. Examples of the substituent include the substituents described as the examples of the substituent to the group represented by L^{B}. As the substituent, alkyl groups, alkenyl groups, alkynyl groups, aryl groups, amino group, alkoxyl groups, aryloxyl groups, acyl groups, alkoxycarbonyl groups, aryloxycarbonyl groups, acyloxyl groups, acylamino groups, alkoxycarbonylamino groups, aryloxycarbonylamino groups, sulfonylamino groups, sulfamoyl groups, carbamoyl groups, alkylthio groups, arylthio groups, sulfonyl group, halogen atoms, cyano group and heterocyclic groups are preferable. Alkyl groups, aryl groups, alkoxyl groups, aryloxyl groups, halogen atoms, cyano group and heterocyclic groups are more preferable. Alkyl groups, aryl groups, alkoxyl groups, aryloxyl groups and aromatic heterocyclic groups are still more preferable, and alkyl groups, aryl groups, alkoxyl groups and aromatic heterocyclic groups are most preferable.

In general formula (B), n^{B2} represents an integer of 1 to 4 and preferably 1 to 3.

Among the five-membered cyclic derivatives having nitrogen atom which are represented by general formula (B) shown above, derivatives represented by the following general formula (B') are more preferable:

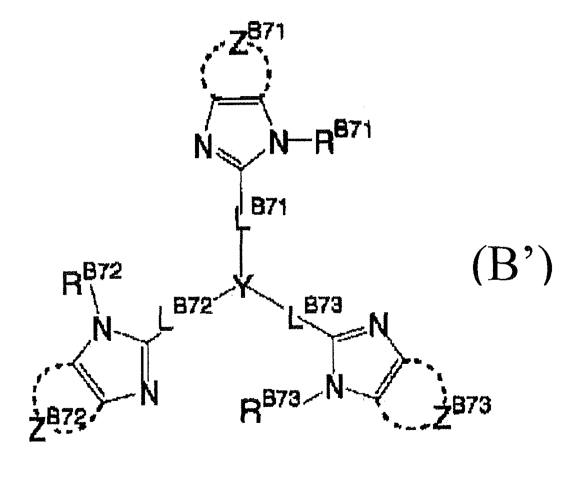

In general formula (B'), R^{B71}, R^{B72} and R^{B73} each represent the same atom or group as those represented by R^{B2} in general formula (B). Preferable examples of the groups represented by R^{B71}, R^{B72} and R^{B73} include the groups described as the preferable examples of the groups represented by R^{B2} in general formula (B).

In general formula (B'), Z^{B71}, Z^{B72} and Z^{B73} each represent the same atom or group as those represented by Z^{B2} in general formula (B). Preferable examples of the groups represented by Z^{B71}, Z^{B72} and Z^{B73} include the groups described as the preferable examples of the groups represented by Z^{B2} in general formula (B).

In general formula (B'), L^{B71}, L^{B72} and L^{B73} each represent a linking group, examples of which include the linking groups described as the examples of the divalent linking group represented by L^{B} in general formula (B). It is preferable that the linking group is a single bond, a divalent aromatic hydrocarbon cyclic group, a divalent aromatic heterocyclic group or a combination of these groups, and more preferably a single bond. The linking groups represented by L^{B71}, L^{B72} and L^{B73} may have substituents. Examples of the substituent include the substituents described as the examples of the substituent to the group represented by L^{B} in general formula (B). Preferable examples of the substituent include the substituents described as the preferable examples of the substituent to the group represented by L^{B} in general formula (B).

In general formula (B'), Y represents nitrogen atom, 1,3,5-benzentriyl group or 2,4,6-triazintriyl group. 1,3,5-Benzentriyl group may have substituents at 2,4,6-positions. Examples of the substituent include alkyl groups, aromatic hydrocarbon cyclic groups and halogen atoms.

Specific examples of the five-membered cyclic derivative having nitrogen atom represented by general formula (B) in which L^{B} represents a group having a functionality of two or greater and the five-membered cyclic derivative having nitrogen atom represented by general formula (B') are shown in the following. However, the five-membered cyclic derivative having nitrogen atom is not limited to the compounds shown as the examples.

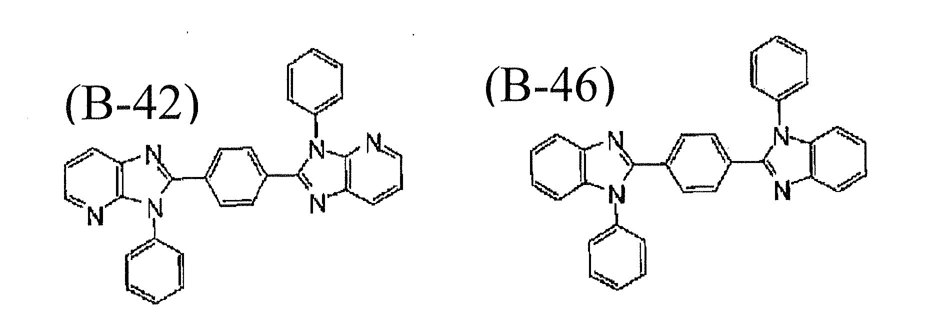

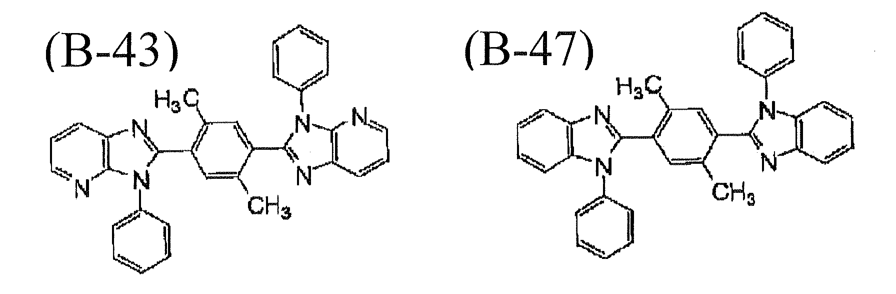

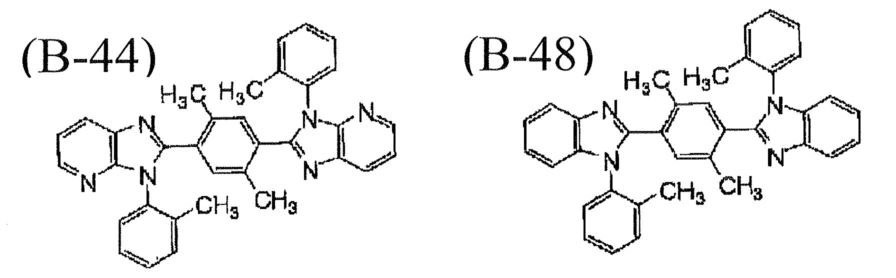

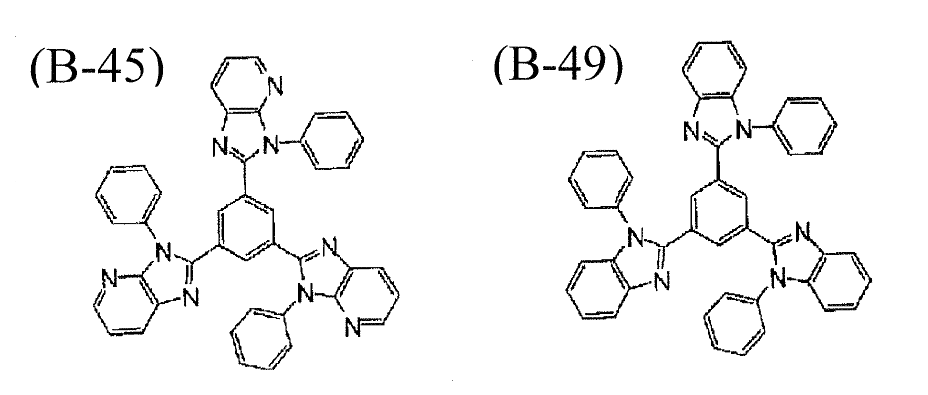

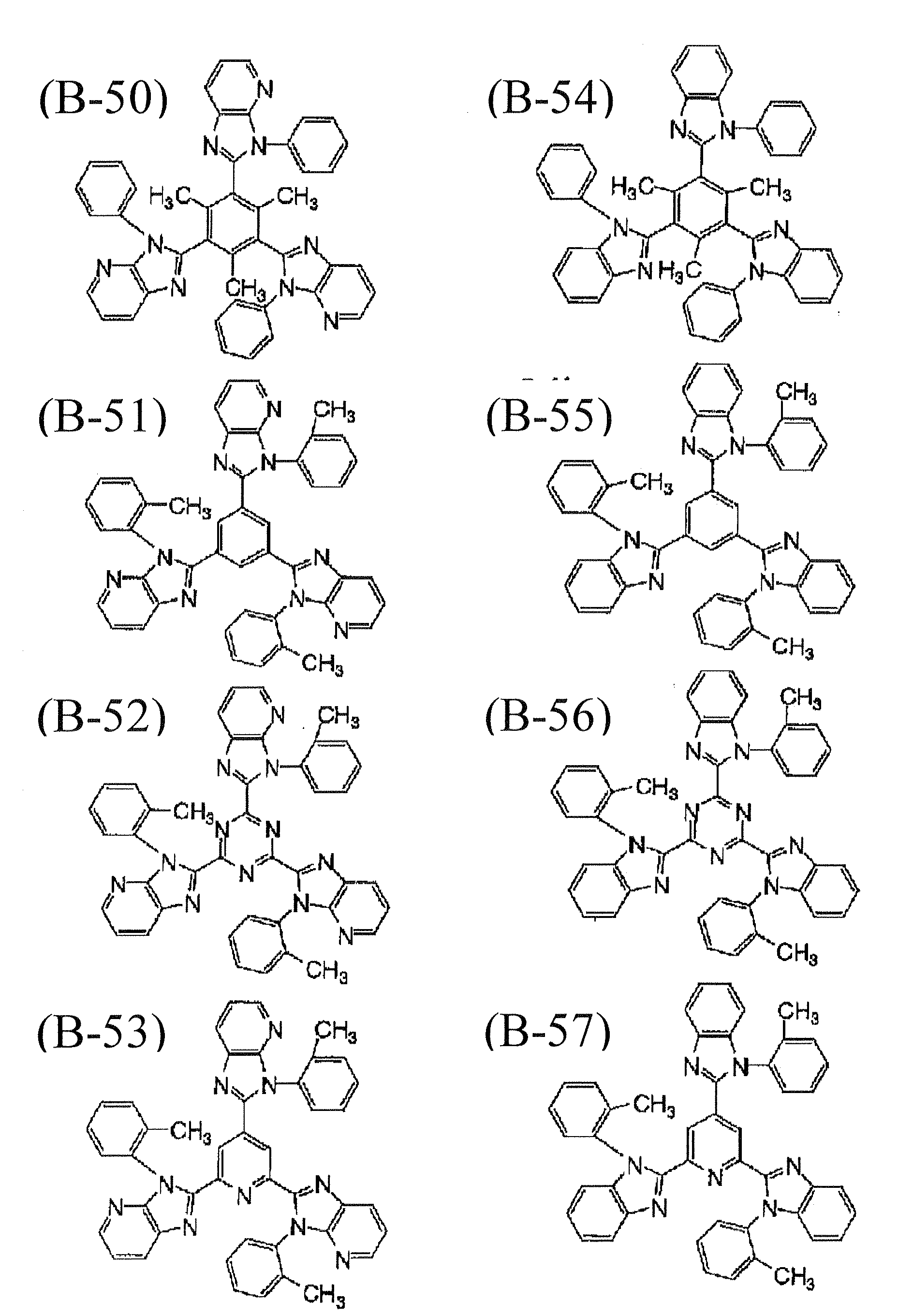

In general formula (C): 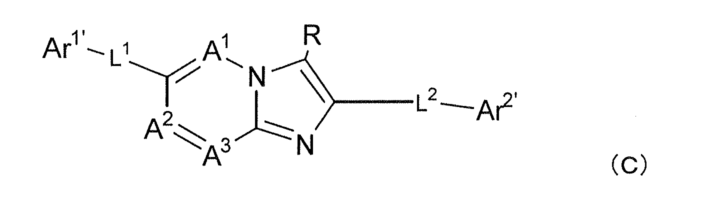 A¹ to A³ each independently represent nitrogen atom or carbon atom.

In the above general formula (C), Ar^{1'} represents a substituted or unsubstituted aryl group having 6 to 60 nuclear carbon atoms (preferably having 6 to 40 nuclear carbon atoms) or a substituted or unsubstituted heteroaryl group having 3 to 60 nuclear carbon atoms (preferably having 3 to 40 nuclear carbon atoms).

Examples of the substituted or unsubstituted aryl group represented by Ar^{1'} include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-chrysenyl group, 2-chrysenyl group, 6-chrysenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, fluoranthenyl group, fluorenyl group, monovalent groups having the spirofluorene structure, perfluorophenyl group, perfluoronaphthyl group, perfluoroanthryl group, perfluorobiphenylyl group, monovalent groups having the 9-phenylanthancene structure, monovalent groups having the 9-(1'-naphthyl)anthracene structure, monovalent groups having the 9-(2'-naphthyl)anthracene structure, monovalent groups having the 6-phenylchrysene structure and monovalent groups having the 9-[4-(diphenylamino)phenyl]anthracene structure. Among these groups, phenyl group, naphthyl groups, biphenyl groups, terphenyl groups, 9-(10-phenyl)anthryl group, 9-[10-(1'-naphthyl)]anthryl group and 9-[10-(2'-naphthyl)]anthryl group are preferable.

Examples of the substituted or unsubstituted heteroaryl group represented by Ar^{1'} include pyrrolyl group, furyl group, thienyl group, silacyclopentadienyl group, pyridyl group, quinolyl group, isoquinolyl group, benzofuryl group, imidazolyl group, pyrimidyl group, carbazolyl group, selenophenyl group, oxadiazolyl group and triazolyl group. Among these groups, pyridyl group, quinolyl group and isoquinolyl group are preferable.

In general formula (C), Ar^{2'} represents hydrogen atom, a substituted or unsubstituted aryl group having 6 to 60 nuclear carbon atoms (preferably having 6 to 40 nuclear carbon atoms), a substituted or unsubstituted heteroaryl group having 3 to 60 nuclear carbon atoms (preferably having 3 to 40 nuclear carbon atoms), a substituted or unsubstituted alkyl group having 1 to 20 nuclear carbon atoms (preferably having 1 to 6 carbon atoms) or a substituted or unsubstituted alkoxyl group having 1 to 20 nuclear carbon atoms (preferably having 1 to 6 carbon atoms).

Examples of the substituted or unsubstituted aryl group represented by Ar^{2'} include the groups described above as the examples of the substituted or unsubstituted aryl group represented by Ar^{1'}.

Examples of the substituted or unsubstituted heteroaryl group represented by Ar^{2'} include the groups described above as the examples of the substituted or unsubstituted heteroaryl group represented by Ar^{1'}.

Examples of the substituted or unsubstituted alkyl group represented by Ar^{2'} include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamantyl group, 2-adamantyl group, 1-norbornyl group and 2-norbornyl group. Among these groups, methyl group, ethyl group and t-butyl group are preferable.

In general formula (C), the substituted or unsubstituted alkoxyl group represented by Ar^{2'} is a group represented by -OY. Examples of the group represented by Y include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group. Among these groups, methyl group, ethyl group and t-butyl group are preferable.

In general formula (C), at least one of the groups represented by Ar^{1'} and Ar^{2'} is a substituted or unsubstituted condensed cyclic group having 10 to 60 nuclear carbon atoms or a substituted or unsubstituted condensed mono-heterocyclic group having 3 to 60 nuclear carbon atoms.

In general formula (C), L¹ and L² each independently represent the single bond, a substituted or unsubstituted arylene group having 6 to 60 nuclear carbon atoms (preferably having 6 to 40 nuclear carbon atoms), a substituted or unsubstituted heteroarylene group having 3 to 60 nuclear carbon atoms (preferably having 3 to 40 nuclear carbon atoms) or a substituted or unsubstituted fluorenylene group.

Examples of the substituted or unsubstituted arylene group represented by L¹ or L² include divalent groups formed by removing hydrogen atom from the aryl groups described above as the examples of the substituted or unsubstituted aryl group represented by the above Ar^{1'}.

Examples of the substituted or unsubstituted heteroarylene group represented by L¹ or L² include divalent groups formed by removing hydrogen atom from the heteroaryl groups described above as the examples of the substituted or unsubstituted heteroaryl group represented by the above Ar^{1'}.

In general formula (C), it is preferable that L¹ and/or L² represent a group selected from the group consisting of

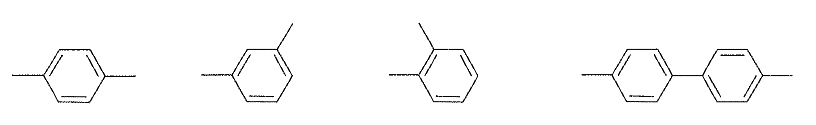

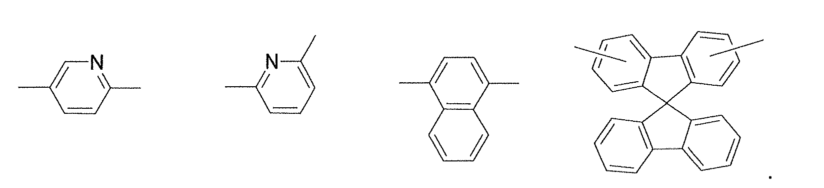

It is preferable that, in general formula (C), Ar^{1'} represents a group represented by one of the following general formulae (4) to (13):

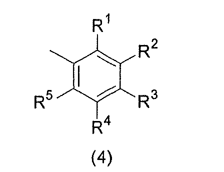

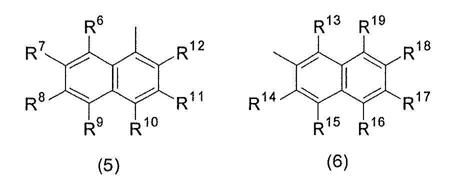

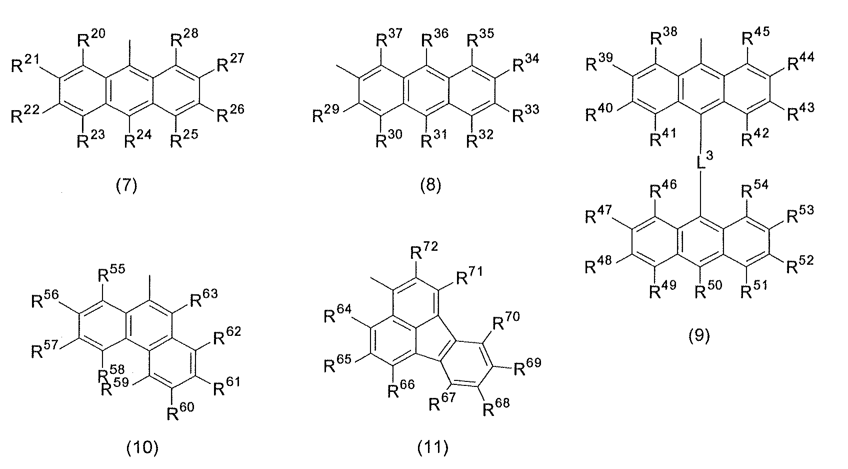

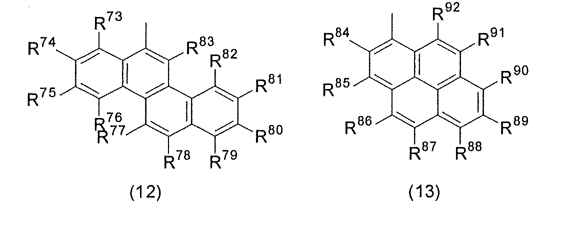

In the above formulae, R¹ to R⁹² each independently represent hydrogen atom, a halogen atom, a substituted or unsubstituted alkyl group having 1 to 20 carbon atoms, a substituted or unsubstituted alkoxyl group having 1 to 20 carbon atoms, a substituted or unsubstituted aryloxyl group having 6 to 40 nuclear carbon atoms, a substituted or unsubstituted diarylamino group having 12 to 80 nuclear carbon atoms, a substituted or unsubstituted aryl group having 6 to 40 nuclear carbon atoms, a substituted or unsubstituted heteroaryl group having 3 to 40 nuclear carbon atoms or a substituted or unsubstituted diarylamino group having 18 to 120 nuclear carbon atoms, and L³ represents the single bond or a group selected from the following groups:

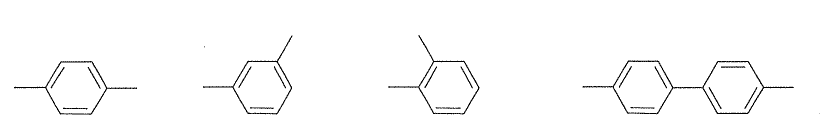

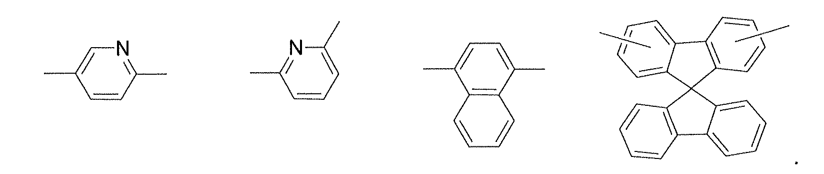

In general formula (C), R represents hydrogen atom, a substituted or unsubstituted aryl group having 6 to 60 nuclear carbon atoms, a substituted or unsubstituted heteroaryl group having 3 to 60 nuclear carbon atoms, a substituted or unsubstituted alkyl group having 1 to 20 carbon atoms or a substituted or unsubstituted alkoxyl group having 1 to 20 carbon atoms.

Examples of the substituted or unsubstituted aryl group represented by R include the groups described above as the examples of the substituted or unsubstituted aryl group represented by the foregoing Ar^{1'}.

Examples of the substituted or unsubstituted heteroaryl group represented by R include the groups described above as the examples of the substituted or unsubstituted heteroaryl group represented by the foregoing Ar^{1'}.

Examples of the substituted or unsubstituted alkyl group represented by R include the groups described above as the examples of the substituted or unsubstituted alkyl group represented by the foregoing Ar^{2'}.

Examples of the substituted or unsubstituted alkoxyl group represented by R include the groups described above as the examples of the substituted or unsubstituted alkoxyl group represented by the foregoing Aᵣ2'.

In general formula (C), n represents an integer of 0 to 5 and preferably 0 to 3. When n represents an integer of 2 or greater, the atoms or groups represented by a plurality of R may be the same with or different from each other, and the groups represented by the plurality of R which are adjacent to each other may be bonded to each other to form an alicyclic carbon ring or an aromatic carbon ring.

Examples of the alicyclic carbon ring include cyclic structures of cyclopentane and cyclohexane.

Examples of the aromatic carbon ring include aromatic structures of benzene, naphthalene, phenanthrene and anthracene.

It is preferable that the five-membered cyclic derivative with a ring having nitrogen atom which is represented by general formula (C) has one of the basic skeleton structures shown in the following as the examples. However, the basic skeleton structure is not limited to those shown as the example.

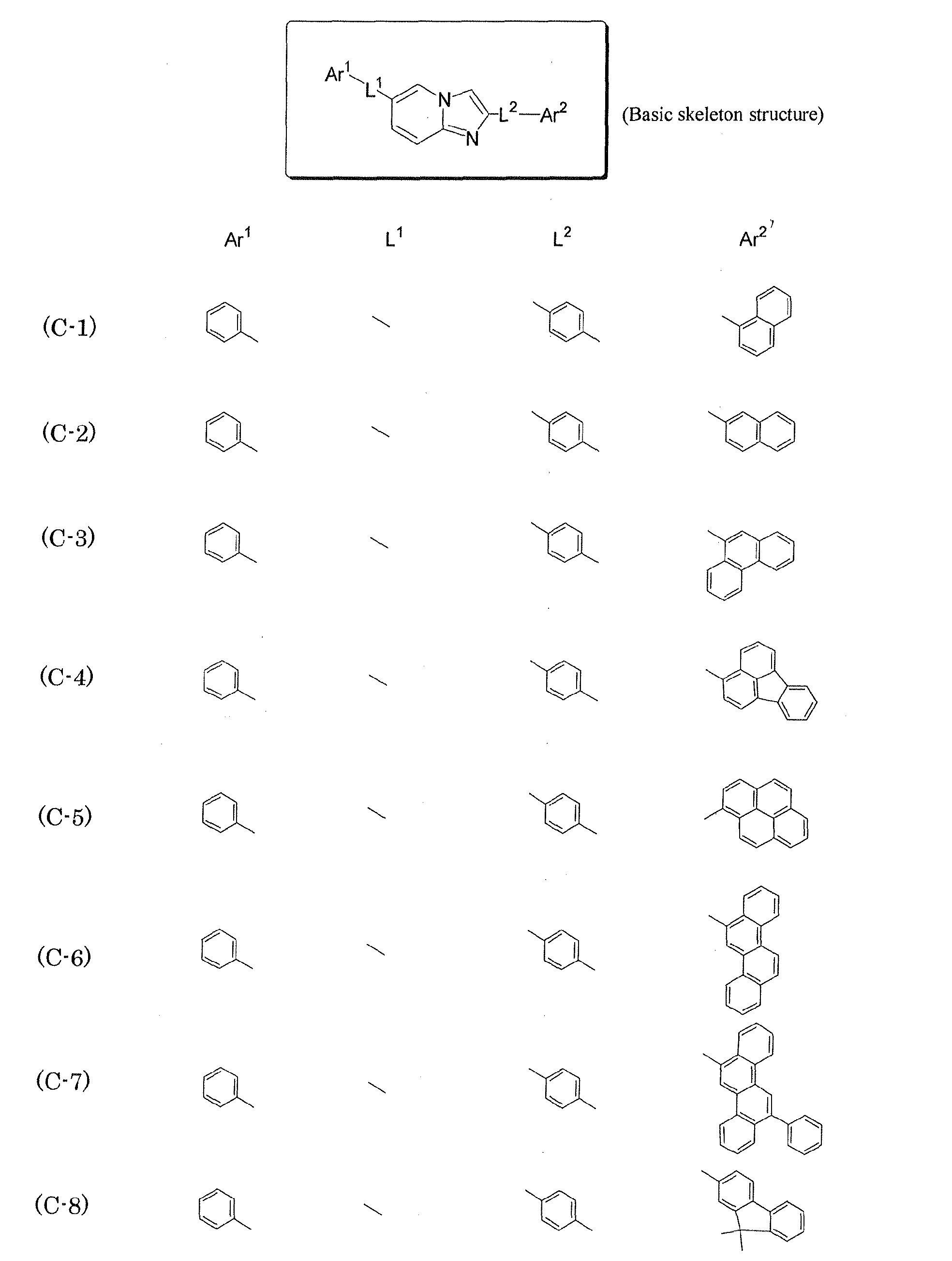

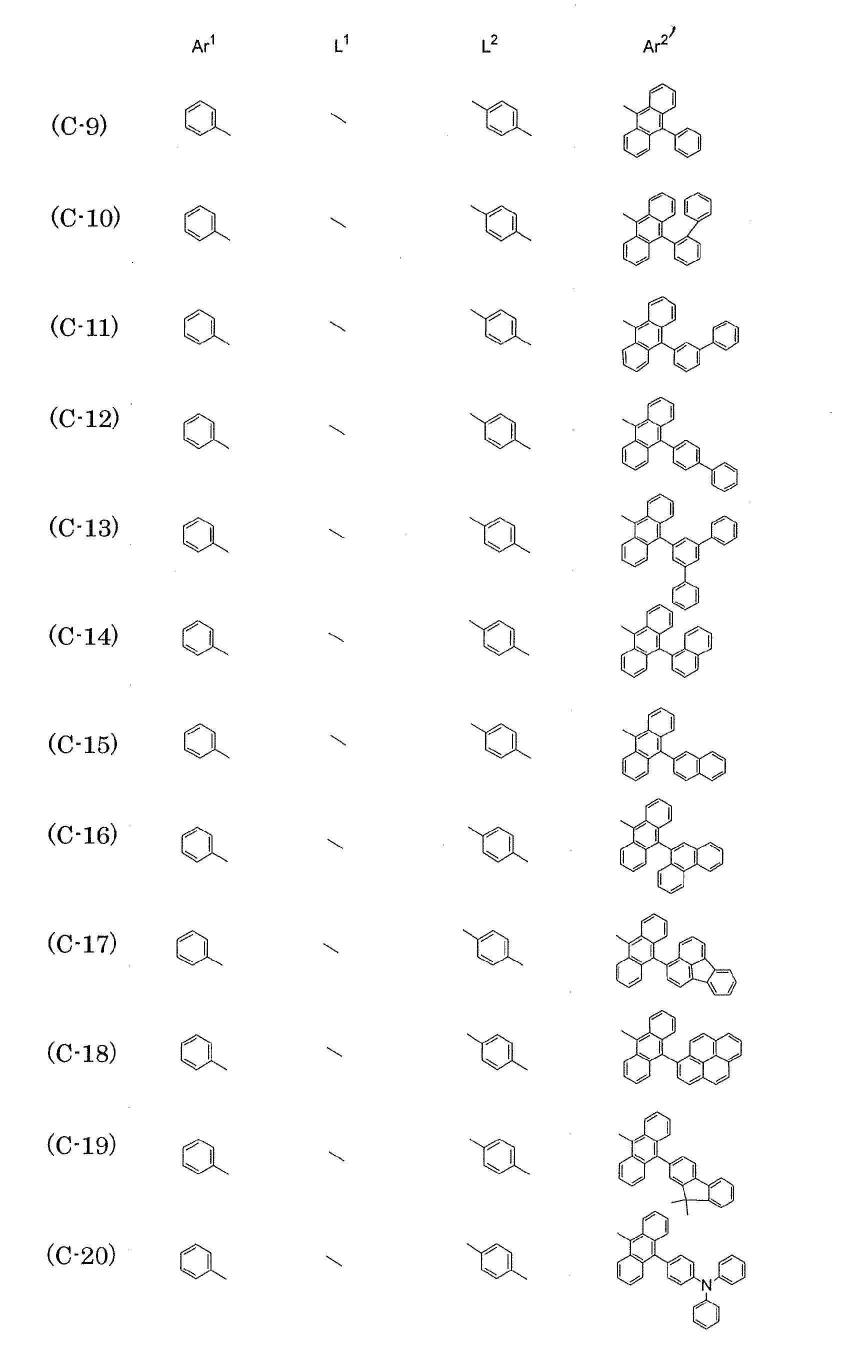

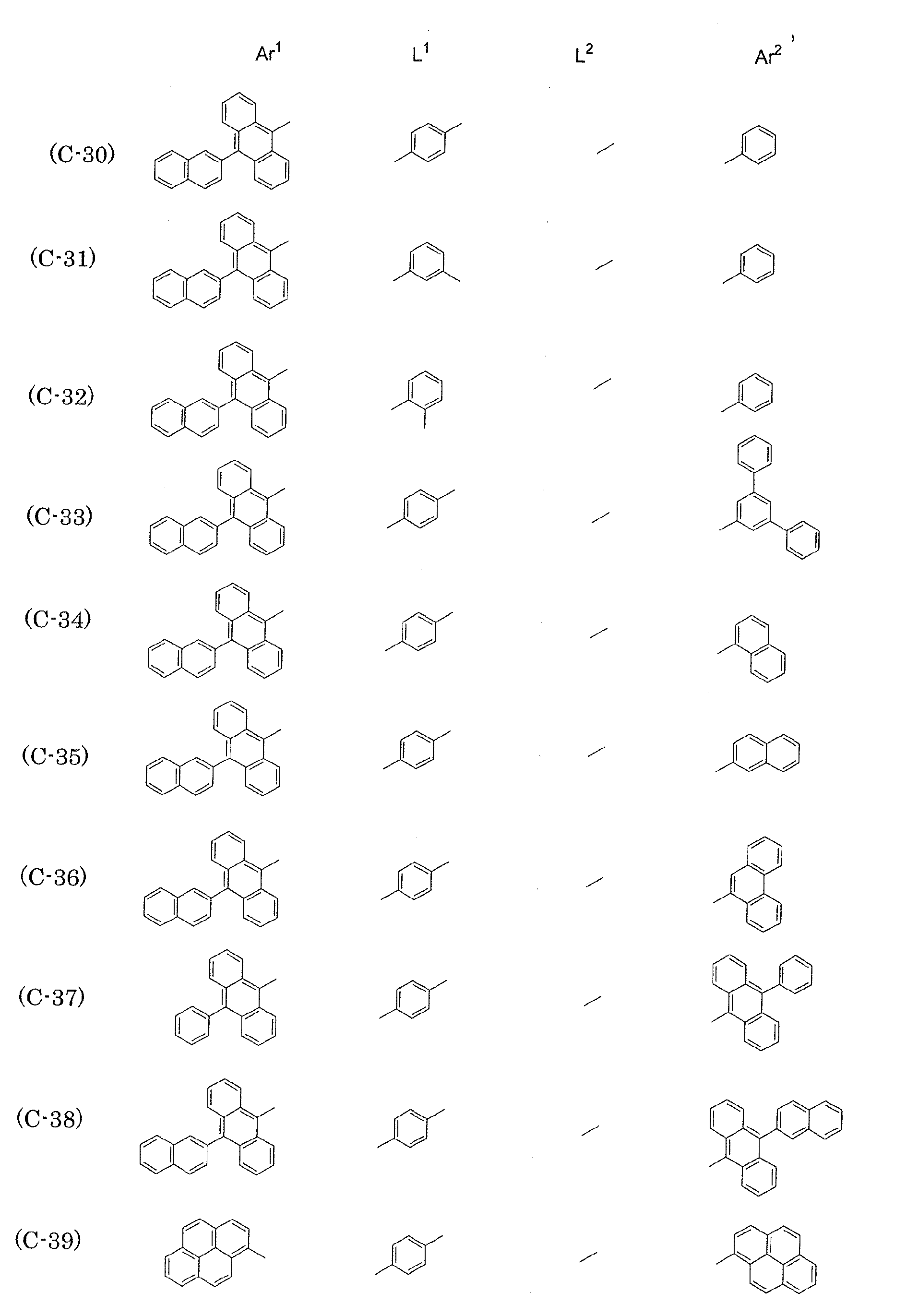

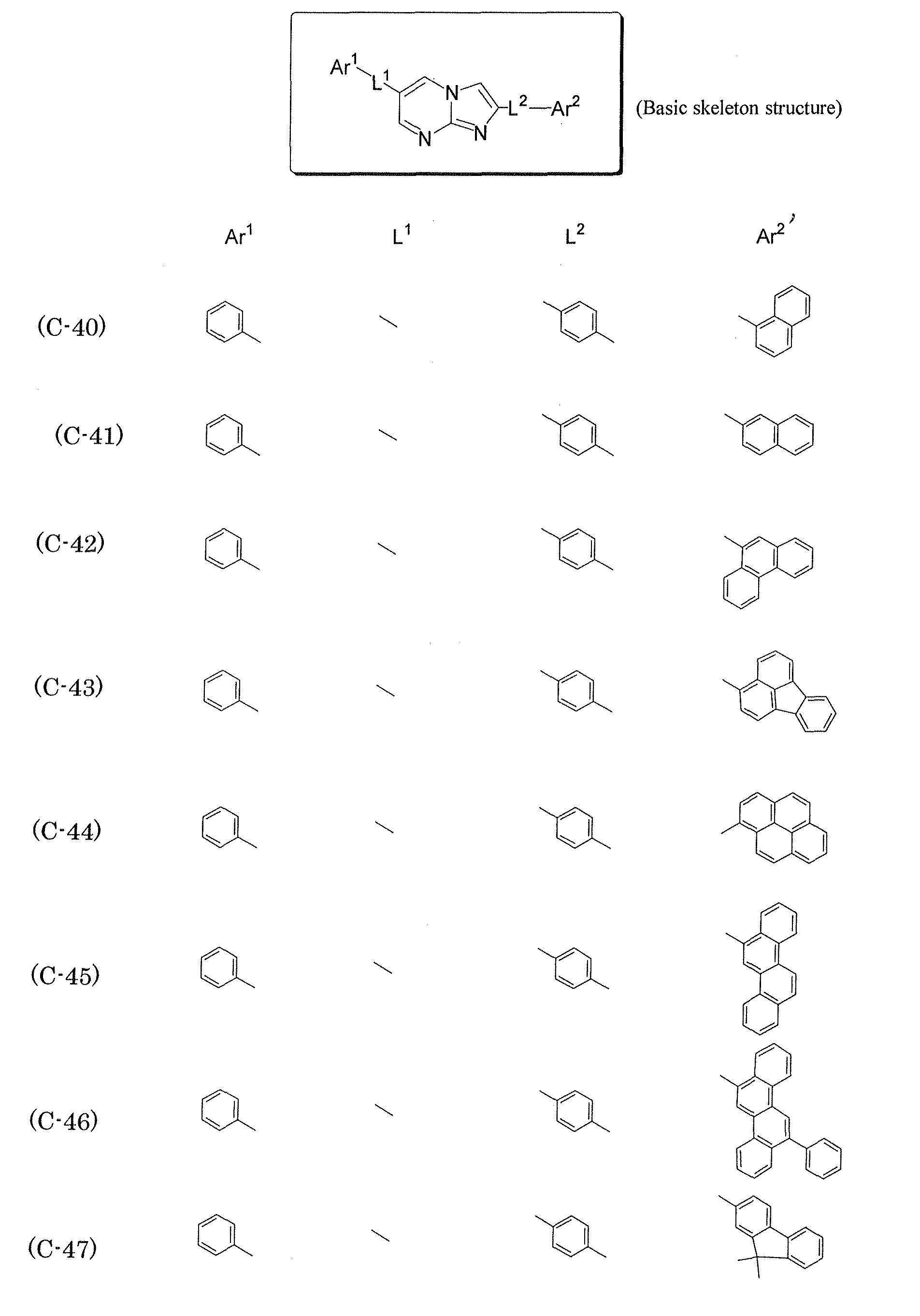

Examples of the non-condensed six-membered ring having nitrogen atom in the non-condensed six-membered cyclic derivative having nitrogen atom described above, which is the main component of the electron injecting layer, include pyridine, pyrazine, pyrimidine and triazine. Among these, pyridine and pyrimidine are preferable. Examples of the non-condensed six-membered cyclic derivative having nitrogen atom include triphenylpyridine, triphenylpyrazine, triphenylpyrimidine, triphenyltriazine and dimers or trimers of these compounds. Among these compounds, the dimers of triphenylpyridine and triphenylpyrimidine are preferable, and the dimer of triphenylpyrimidine is more preferable.

The non-condensed six-membered cyclic derivative having nitrogen atom may have substituents. As the substituent, alkyl groups, alkenyl groups, alkynyl groups, aromatic hydrocarbon groups, amino groups, alkoxyl groups, aryloxyl groups, acyl groups, alkoxycarbonyl groups, aryloxycarbonyl groups, acyloxyl groups, acylamino groups, alkoxycarbonylamino groups, aryloxycarbonylamino groups, sulfonylamino groups, sulfamoyl groups, carbamoyl groups, alkylthio groups, arylthio groups, sulfonyl group, halogen atoms, cyano group and aromatic heterocyclic groups are preferable. Alkyl groups, aryl groups, alkoxyl groups, aryloxyl groups, halogen atoms, cyano group and aromatic heterocyclic groups are more preferable. Alkyl groups, aryl groups, alkoxyl groups, aryloxyl groups and aromatic heterocyclic groups are still more preferable, and alkyl groups, aryl groups, alkoxyl groups and aromatic heterocyclic groups are most preferable.

Examples of the condensed six-membered ring having nitrogen atom in the condensed six-membered cyclic derivatives having nitrogen atom and one condensed carbon ring, which is the main component of the electron injecting layer described above, include quinoxaline, quinoline, isoquinoline and benzopyrimidine. Among these, quinoline and benzopyrimidine are preferable. Examples of the condensed six-membered cyclic derivatives having nitrogen atom and one condensed carbon ring include triphenylquinoxaline, triphenylquinoline, triphenylbenzopyrimidine and dimers or trimers of these derivatives. Among these derivatives, the dimers of triphenylquinoline and triphenylbenzopyrimidine are preferable and the dimer of triphenylpyrimidine is more preferable.

The condensed six-membered cyclic derivatives having nitrogen atom and one condensed carbon ring may have substituents. As the substituent, alkyl groups, alkenyl groups, alkynyl groups, aromatic hydrocarbon groups, amino groups, alkoxyl groups, aryloxyl groups, acyl groups, alkoxycarbonyl groups, aryloxycarbonyl groups, acyloxyl groups, acylamino groups, alkoxycarbonylamino groups, aryloxycarbonylamino groups, sulfonylamino groups, sulfamoyl groups, carbamoyl groups, alkylthio groups, arylthio groups, sulfonyl group, halogen atoms, cyano group and aromatic heterocyclic groups are preferable. Alkyl groups, aryl groups, alkoxyl groups, aryloxyl groups, halogen atoms, cyano group and aromatic heterocyclic groups are more preferable. Alkyl groups, aryl groups, alkoxyl groups, aryloxyl groups and aromatic heterocyclic groups are still more preferable, and alkyl groups, aryl groups, alkoxyl groups and aromatic heterocyclic groups are most preferable.

It is essential that the electron injecting layer in the present invention comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as the main component and further comprises at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds as the reductive dopant. Examples of the alkali metal compound, the alkaline earth metal compound and the rare earth metal compound described above include oxides and halides of the respective metals. The reductive dopant used in the present invention is defined as a compound which is added to the interfacial region between the electron injecting layer and the cathode and enhances the effect of electron injection. It is preferable that the reductive dopant is added to the region described above. At least a portion of the organic layer comprised in the interfacial region is reduced to form anions.

Examples of the alkali metal include Na (the work function: 2.36 eV), K (the work function: 2.28 eV), Rb (the work function: 2.16 eV) and Cs (the work function: 1.95 eV). Alkali metals having a work function of 2.9 eV or smaller are preferable. Among these alkali metals, K, Rb and Cs are preferable, Rb and Cs are more preferable, and Cs is most preferable.

Examples of the alkaline earth metal include Ca (the work function: 2.9 eV), Sr (the work function: 2.0 to 2.5 eV) and Ba (the work function: 2.52 eV). Alkaline earth metals with a work function of 2.9 eV or smaller are preferable.

Examples of the rare earth metal include Sc, Y, Ce, Tb and Yb. Rare earth metals with a work function of 2.9 eV or smaller are preferable.

When the preferable metals among the above metals are used, the luminance of the emitted light and the life of the organic EL device can be increased by addition of the metals into the electron injecting layer in a relatively small amount since these metals have great reducing ability.

Examples of the alkali metal compound described above include alkali metal oxides such as Li₂O, Cs₂O and K₂O and alkali metal halides such as LiF, NaF, CsF and KF. Among these compounds, alkali metal oxides and alkali metal fluorides such as LiF, Li₂O and NaF are preferable.

Examples of the alkaline earth metal compound described above include BaO, SrO, CaO and mixtures thereof such as BaₓSr₁₋ₓO (0<x<1) and BaₓCa₁₋ₓO (0<x<1). Among these compounds, BaO, SrO and CaO are preferable.

Examples of the rare earth metal compound described above include YbF₃, ScF₃, ScO₃, Y₂O₃, Ce₂O₃, GdF₃ and TbF₃. Among these compounds, YbF₃, ScF₃ and TbF₃ are preferable.

The alkali metal complex, the alkaline earth metal complex and the rare earth metal complex are not particularly limited as long as the complexes contain at least one of the alkali metal ions, the alkaline earth metal ions and rare earth metal ions, respectively, as the metal ion. As the ligand, quinolinol, benzoquinolinol, acridinol, phenanthridinol, hydroxyphenyloxazole, hydroxyphenylthiazole, hydroxydiaryloxadiazoles, hydroxydiarylthiadiazoles, hydroxyphenylpyridine, hydroxyphenylbenzimidazole, hydroxybenzotriazole, hydroxyflavone, bipyridyl, phenanthroline, phthalocyanine, porphyrin, cyclopentadiene, β-diketones, azomethines and derivatives of these compounds are preferable. However, the ligand is not limited to the ligands described above.

As for the addition form of the reductive dopant, it is preferable that the reductive dopant is added in a manner such that a layer or islands are formed in the interfacial region described above. As the process for adding the reductive dopant, it is preferable that an organic material which is the light emitting material or the electron injecting material forming the interfacial region is vaporized while the reductive dopant is simultaneously vapor deposited in accordance with the resistance heating deposition method so that the reductive dopant is dispersed in the organic material. The concentration of the dispersion expressed as the ratio of the amounts by mole of the organic substance to the reductive dopant is in the range of 100:1 to 1:100 and preferably in the range of 5:1 to 1:5.

When the reductive dopant is added to form a layer, the reductive dopant alone is vapor deposited in accordance with the resistance heating deposition method to form a layer preferably having a thickness of 0.1 to 15 nm after a layer of the organic material such as the light emitting material and the electron injecting material is formed as the interfacial region.

When the reductive dopant is added to form islands, the reductive dopant alone is vapor deposited in accordance with the resistance heating deposition method to form islands preferably having a thickness of 0.1 to 15 nm after islands of the organic material such as the light emitting material and the electron injecting material were formed as the interfacial region.

It is preferable that the relative amounts by mole of the main component and the reductive dopant in the electron injecting layer of the organic EL device of the present invention is in the range of 5:1 to 1:5 and more preferably in the range of 2:1 to 1:2.

Typical examples of the construction of the organic EL device include an anode / a light emitting layer / an electron injecting layer / a cathode; an anode / a hole injecting layer / a light emitting layer / an electron injecting layer / a cathode; an anode / a hole injecting layer / a hole transporting layer / a light emitting layer / an electron injecting layer / a cathode; and an anode / an insulating layer / a hole injecting layer / a hole transporting layer / a light emitting layer / an electron injecting layer / a cathode.

It is preferable that the light emitting layer in the organic EL device of the present invention comprises a host material and a phosphorescent metal complex. As the phosphorescent metal complex, iridium complexes, osmium complexes and platinum complexes are preferable, iridium complexes and platinum complexes are more preferable, and iridium complexes are most preferable since the quantum yield of phosphorescence is great and the external quantum efficiency of the light emitting device can be further increased.

As for the form of the complex, metal complexes in the form of ortho metals are preferable. The metal complex in the form of the ortho metal is the terminology generally expressing a group of compounds described, for example, in "Chemistry of orgametallic compounds-Fundamentals and Application", pages 150 and 232, by Akeo Yamamoto, published by Shokabo Co., Ltd., 1982; and "Photochemistry and Photophysics of Coordination Compounds", pages 71 to 77 and 135 to 146, by H. Yershin, published by Springer Verlag, 1987. As the central metal of the above metal complex, any transition metal can be used. In the present invention, rhodium, platinum, gold, iridium, ruthenium and palladium are preferable, and iridium is more preferable.

The valence of the metal in the metal complex in the form of ortho metal is not particularly limited. When iridium is used, trivalent iridium is preferable. The ligand in the metal in the metal complex in the form of ortho metal is not particularly limited as long as the metal complex in the form of ortho metal can be formed. Preferable examples of the ligand include aromatic heterocyclic derivatives having nitrogen atom which is substituted with an aryl group (the aryl group is bonded to the carbon atom adjacent to the nitrogen atom of the aromatic heteroring having nitrogen atom, examples of the aryl group include phenyl group, naphthyl group, anthracenyl group and pyrenyl group, and examples of the aromatic heteroring having nitrogen atom include pyridine, pyrimidine, pyrazine, pyridazine, quinoline, isoquinoline, quinoxaline, phthalazine, quinazoline, naphthylidine, cinnoline, pyrimidine, phenanthroline, pyrrol, imidazole, pyrazole, oxazole, oxadiazole, triazole, thiadiazole, benzimidazole, benzoxazole, benzothiazole and phenanthrolidine), aromatic heterocyclic derivatives having nitrogen atom which is substituted with a heteroaryl group (the heteroaryl group is bonded to the carbon atom adjacent to the nitrogen atom of the aromatic heteroring having nitrogen atom, and examples of the heteroaryl group include the groups having the aromatic heterocyclic derivatives having nitrogen atom described above, thiophenyl group and furyl group), 7,8-benzoquinoline derivatives, phosphinoaryl derivatives, phosphinoheteroaryl derivatives, phosphinoxyaryl derivatives, phosphinoxyheteroaryl derivatives, aminomethylaryl derivatives and aminomethylheteroaryl derivatives. Among these ligands, aromatic heterocyclic derivatives having nitrogen atom which is substituted with an aryl group, aromatic heterocyclic derivatives having nitrogen atom which is substituted with a heteroaryl group and 7,8-benzoquinoline derivatives are preferable. Phenylpyridine derivatives, thiophenyl- pyridine derivatives and 7,8-benzoquinoline derivatives are more preferable, and thiophenylpyridine derivatives and 7,8-benzoquinoline derivatives are most preferable.

Examples of the metal complex in the form of ortho metal are shown in the following. However, the metal complex in the form of ortho metal is not limited to the compounds shown as the examples.

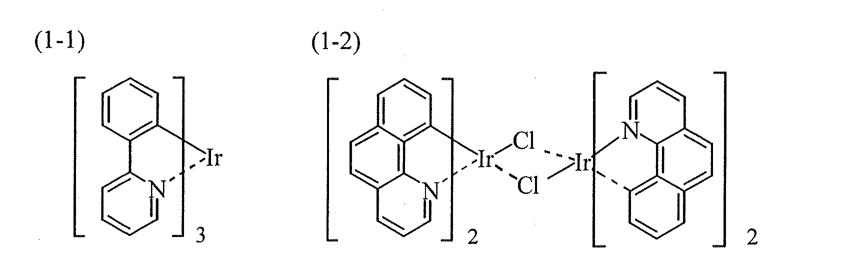

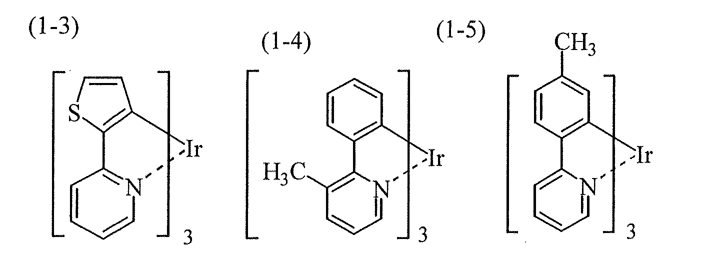

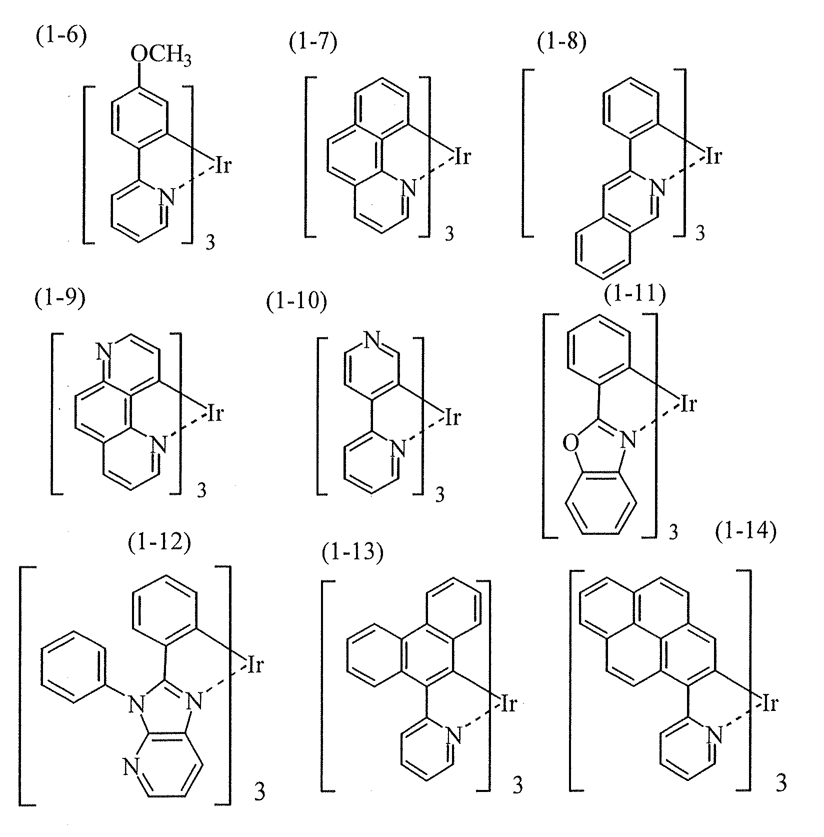

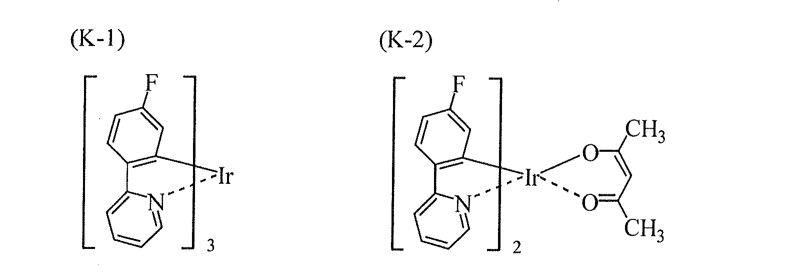

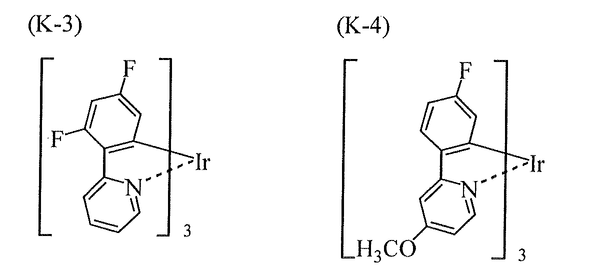

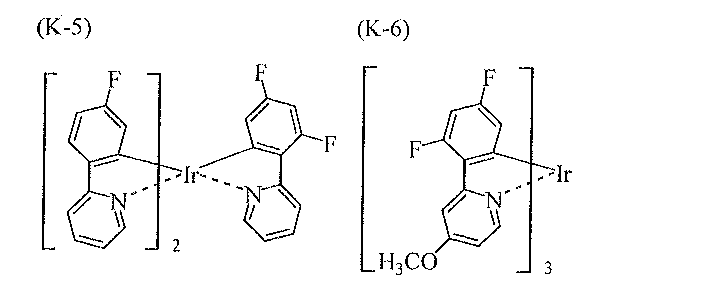

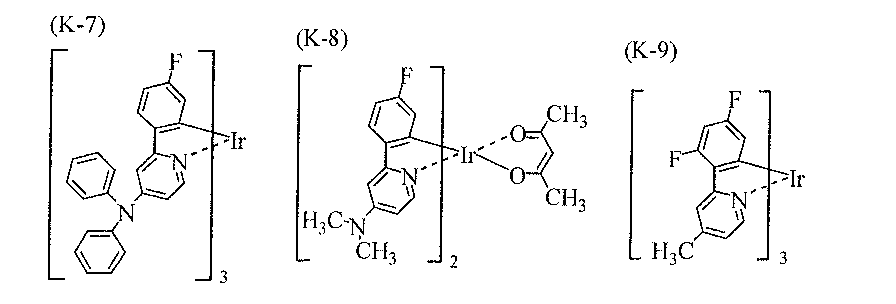

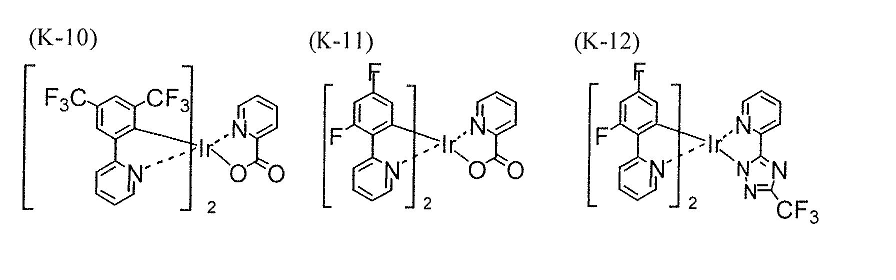

The electron injecting layer in the organic EL device of the present invention is as described specifically in the above.

In the organic EL device of the present invention, an electron transporting layer formed with an insulating material or a semiconductor may be further sandwiched between the cathode and the organic thin film layer. The electron transporting layer effectively prevents leak in the electric current and improves the electron injecting property.

It is preferable that at least one metal compound selected from the group consisting of alkali metal chalcogenides, alkaline earth metal chalcogenides, alkali metal halides and alkaline earth metal halides is used as the insulating material. It is preferable that the electron transporting layer is constituted with the above alkali metal chalcogenide since the electron injecting property can be improved. Preferable examples of the alkali metal chalcogenide include Li₂O, LiO, Na₂S, Na₂Se and NaO. Preferable examples of the alkaline earth metal chalcogenide include CaO, BaO, SrO, BeO, BaS and CaSe. Preferable examples of the alkali metal halide include LiF, NaF, KF, LiCl, KCl and NaCl. Preferable examples of the alkaline earth metal halide include fluorides such as CaF₂, BaF₂, SrF₂, MgF₂ and BeF₂ and halides other than the fluorides.

Examples of the semiconductor constituting the electron transporting layer include oxides, nitrides and oxide nitrides containing at least one element selected from Ba, Ca, Sr, Yb, Al, Ga, In, Li, Na, Cd, Mg, Si, Ta, Sb and Zn, which are used singly or in combination of two or more. It is preferable that the inorganic compound constituting the electron transporting layer is in the form of a fine crystalline or amorphous insulating thin film. When the electron transporting layer is constituted with the above insulating thin film, a more uniform thin film can be formed and defective pixels such as dark spots can be decreased. Examples of the inorganic compound include the alkali metal chalcogenides, the alkaline earth metal chalcogenides, the alkali metal halides and the alkaline earth metal halides which are described above.

The hole injecting layer and the hole transporting layer are layers which help injection of holes into the light emitting layer and transport holes to the light emitting region. The layers exhibit a great mobility of holes and, in general, have an ionization energy as small as 5.5 eV or smaller. For the hole injecting layer and the hole transporting layer, a material which transports holes to the light emitting layer under a small strength of the electric field is preferable. A material which exhibits, for example, a mobility of holes of at least 10⁻⁶ cm²/V·second under application of an electric field of 10⁴ to 10⁶ V/cm is preferable.

The anode of the organic EL device plays the role of injecting holes into the hole transporting layer or the light emitting layer. It is effective that the anode has a work function of 4.5 eV or greater. Examples of the material of the anode used in the present invention include indium tin oxide alloys (ITO), tin oxides (NESA), gold, silver, platinum and copper. As the cathode, a material having a small work function is preferable so that electrons can be injected into the electron transporting layer or the light emitting layer. The material of the cathode is not particularly limited. Examples of the material of the cathode include indium, aluminum, magnesium, magnesium-indium alloys, magnesium-aluminum alloys, aluminum-lithium alloys, aluminum-scandium-lithium alloys and magnesium-silver alloys.

The process for forming the layers in the organic EL device of the present invention is not particularly limited. A conventional process such as the vacuum vapor deposition process and the spin coating process can be used. The organic thin film layer used in the organic EL device of the present invention can be formed in accordance with the vacuum vapor deposition process, the molecular beam epitaxy process (the MBE process) or, using a solution prepared by dissolving the compound into a solvent, in accordance with a conventional coating process such as the dipping process, the spin coating process, the casting process, the bar coating process and the roller coating process.

The thickness of each layer in the organic thin film layer in the organic EL device of the present invention is not particularly limited. In general, an excessively thin layer tends to have defects such as pin holes, and an excessively thick layer requires a high applied voltage results in decreasing the efficiency. Therefore, a thickness within the range of several nanometers to 1 µm is preferable.

The present invention will be described more specifically with reference to examples in the following. However, the present invention is not limited to the examples.

### Example 1

A glass substrate (manufactured by GEOMATEC Company) of 25 mm×75 mm ×1.1 mm thickness having an ITO transparent electrode was cleaned by application of ultrasonic wave in isopropyl alcohol for 5 minutes and then by exposure to ozone generated by ultraviolet light for 30 minutes. The glass substrate having the transparent electrode which had been cleaned was adhered to a substrate holder of a vacuum vapor deposition apparatus. On the surface of the cleaned substrate at the side having the transparent electrode, a film of copper phthalocyanine (referred to as a film of CuPc, hereinafter) having a thickness of 10 nm was formed in a manner such that the formed film covered the transparent electrode. The formed film of CuPc worked as the hole injecting layer. On the formed film of CuPc, a film of 4,4'-bis[N-(1-naphthyl)-N-phenylamino]biphenyl shown below (referred to as a film of α-NPD, hereinafter) having a thickness of 30 nm was formed. The formed film of α-NPD worked as the hole transporting layer. On the formed film of α-NPD, a film of a compound CBP shown below having a thickness of 40 nm was formed by vapor deposition as the light emitting layer. At the same time, the foregoing phosphorescent Ir metal complex (K-3) on page 69 was added to the light emitting layer. The content of the Ir metal complex (K-3) in the light emitting layer was 7% by weight. On the film formed above, (1,1'-bisphenyl)-4-olato)bis(2-methyl-8-quinolinolato)aluminum (the foregoing compound (A-5) on page 25) as the main component of the film and Li (the source of lithium: manufactured by SAES GETTERS Company) as the reductive dopant were binary vapor deposited in amounts such that the ratio of the amounts by mole of the compound (A-5) to Li was 3:1 to form a film having a thickness of 10 nm, and an (A-5):Li film was formed as the electron injecting layer at the side of the cathode. On the formed (A-5):Li film, metallic aluminum was vapor deposited to form a metal cathode, and an organic EL device was prepared.

The obtained device emitted bluish green light with a luminance of emitted light of 102 cd/m² and an efficiency of light emission of 7.67 cd/A under application of a direct electric current of 7.8 V. When the device was driven under a constant electric current at an initial luminance of 200 cd/m², the time before the luminance decreased to a half of the initial value (the half life) was 350 hours.

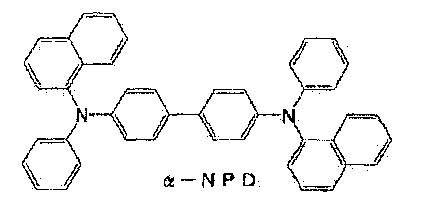

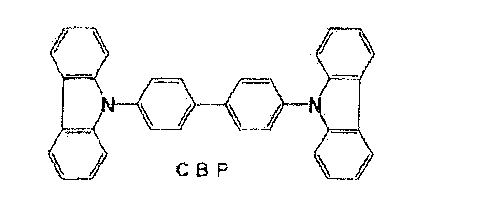

### Example 2

An organic EL device was prepared in accordance with the same procedures as those conducted in Example 1 except that the foregoing compound (B-45) on page 45 was used for the electron injecting layer in place of the compound (A-5), and the luminance of emitted light, the efficiency of light emission and the half life were measured in accordance with the same procedures as those conducted in Example 1. The results are shown in Table 1.

### Example 3

An organic EL device was prepared in accordance with the same procedures as those conducted in Example 1 except that the foregoing compound (B-49) on page 45 was used for the electron injecting layer in place of the compound (A-5) and Cs was used as the reductive dopant in place of Li, and the luminance of emitted light, the efficiency of light emission and the half life were measured in accordance with the same procedures as those conducted in Example 1. The results are shown in Table 1.

### Example 4

An organic EL device was prepared in accordance with the same procedures as those conducted in Example 1 except that the foregoing Ir metal complex (K-10) on page 69 was used for the light emitting layer in place of (K-3), and the luminance of emitted light, the efficiency of light emission and the half life were measured in accordance with the same procedures as those conducted in Example 1. The results are shown in Table 1.

### Example 5

An organic EL device was prepared in accordance with the same procedures as those conducted in Example 4 except that TCTA shown below was used for the hole transporting layer in place of the compound α-NPD, and the luminance of emitted light, the efficiency of light emission and the half life were measured in accordance with the same procedures as those conducted in Example 4. The results are shown in Table 1.

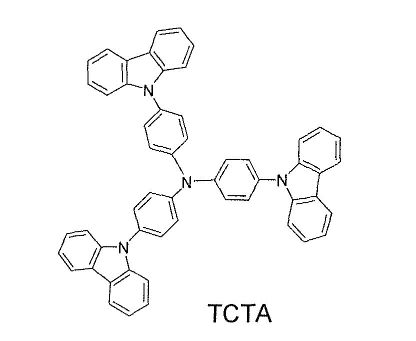

### Example 6

An organic EL device was prepared in accordance with the same procedures as those conducted in Example 5 except that the foregoing compound (B-7) on page 34 was used for the electron injecting layer in place of the compound (A-5), and the luminance of emitted light, the efficiency of light emission and the half life were measured in accordance with the same procedures as those conducted in Example 5. The results are shown in Table 1.

### Example 7

An organic EL device was prepared in accordance with the same procedures as those conducted in Example 5 except that the foregoing compound (C-15) on page 57 was used for the electron injecting layer in place of the compound (A-5), and the luminance of emitted light, the efficiency of light emission and the half life were measured in accordance with the same procedures as those conducted in Example 5. The results are shown in Table 1.

### Example 8

After the light emitting layer was formed in accordance with the same procedures as those conducted in Example 5, a film of the compound (A-5) alone having a thickness of 10 nm was formed as the electron injecting layer. On the formed film, the compound (A-5) as the main component of the film and Li (the source of lithium: manufactured by SAES GETTERS Company) as the reductive dopant were binary vapor deposited in amounts such that the ratio of the amounts by mole of the compound (A-5) to Li was 3:1 in accordance with the same procedures as those conducted in Example 5 to form a film having a thickness of 10 nm, and an (A-5):Li film was formed as the electron injecting layer at the side of the cathode. On the formed (A-5):Li film, metallic aluminum was vapor deposited to form a metal cathode, and an organic EL device was prepared. The luminance of emitted light, the efficiency of light emission and the half life were measured. The results are shown in Table 1.

### Example 9

An organic EL device was prepared in accordance with the same procedures as those conducted in Example 8 except that the compound (B-7) shown above was used for the electron injecting layer in place of the compound (A-5), and the luminance of emitted light, the efficiency of light emission and the half life were measured in accordance with the same procedures as those conducted in Example 8. The results are shown in Table 1.

### Example 10

An organic EL device was prepared in accordance with the same procedures as those conducted in Example 8 except that the compound (C-15) shown above was used for the electron injecting layer in place of the compound (A-5), and the luminance of emitted light, the efficiency of light emission and the half life were measured in accordance with the same procedures as those conducted in Example 8. The results are shown in Table 1.

### Comparative Example 1

An organic EL device was prepared in accordance with the same procedures as those conducted in Example 1 except that Li as the reductive dopant was not added to the electron injecting layer, and the luminance of emitted light, the efficiency of light emission and the half life were measured in accordance with the same procedures as those conducted in Example 1. The results are shown in Table 1.

### Comparative Example 2

An organic EL device was prepared in accordance with the same procedures as those conducted in Example 5 except that Li as the reductive dopant was not added to the electron injecting layer, and the luminance of emitted light, the efficiency of light emission and the half life were measured in accordance with the same procedures as those conducted in Example 5. The results are shown in Table 1.

### Comparative Example 3

An organic EL device was prepared in accordance with the same procedures as those conducted in Example 2 except that Li as the reductive dopant was not added to the electron injecting layer, and the luminance of emitted light, the efficiency of light emission and the half life were measured in accordance with the same procedures as those conducted in Example 2. The results are shown in Table 1.

### Comparative Example 4

An organic EL device was prepared in accordance with the same procedures as those conducted in Example 6 except that Li as the reductive dopant was not added to the electron injecting layer, and the luminance of emitted light, the efficiency of light emission and the half life were measured in accordance with the same procedures as those conducted in Example 6. The results are shown in Table 1.

### Comparative Example 5

An organic EL device was prepared in accordance with the same procedures as those conducted in Example 7 except that Li as the reductive dopant was not added to the electron injecting layer, and the luminance of emitted light, the efficiency of light emission and the half life were measured in accordance with the same procedures as those conducted in Example 7. The results are shown in Table 1.

### Comparative Example 6

An organic EL device was prepared in accordance with the same procedures as those conducted in Example 1 except that the compound (BCP) shown below was used for the electron injecting layer in place of the compound (A-5), and the luminance of emitted light, the efficiency of light emission and the half life were measured in accordance with the same procedures as those conducted in Example 1. The results are shown in Table 1.

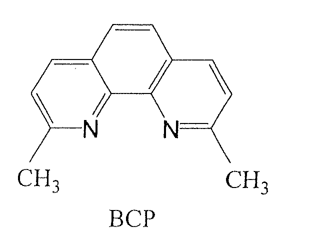

### Comparative Example 7

An organic EL device was prepared in accordance with the same procedures as those conducted in Example 8 except that the compound BCP shown above was used for the electron injecting layer in place of the compound (A-5), and the luminance of emitted light, the efficiency of light emission and the half life were measured in accordance with the same procedures as those conducted in Example 8. The results are shown in Table 1.

### Comparative Example 8

An organic EL device was prepared in accordance with the same procedures as those conducted in Example 3 except that the compound BCP shown above was used for the electron injecting layer in place of the compound (B-49), and the luminance of emitted light, the efficiency of light emission and the half life were measured in accordance with the same procedures as those conducted in Example 3. The results are shown in Table 1.

**Table 1 - 1**

| | Electron injecting layer | | Hole transporting layer | Light emitting layer, Ir metal complex |
|---|---|---|---|---|
| | main component | reducing dopant | | |
| Example 1 | (A-5) | Li | α-NPD | (K-3) |
| Example 2 | (B-45) | Li | α-NPD | (K-3) |
| Example 3 | (B-49) | Cs | α-NPD | (K-3) |
| Example 4 | (A-5) | Li | α-NPD | (K-10) |
| Example 5 | (A-5) | Li | TCTA | (K-10) |
| Example 6 | (B-7) | Li | TCTA | (K-10) |
| Example 7 | (C-15) | Li | TCTA | (K-10) |
| Example 8 | (A-5) | Li | TCTA | (K-10) |
| Example 9 | (B-7) | Li | TCTA | (K-10) |
| Example 10 | (C-15) | Li | TCTA | (K-10) |
| Comparative Example 1 | (A-5) | - | α-NPD | (K-3) |
| Comparative Example 2 | (A-5) | - | TCTA | (K-10) |
| Comparative Example 3 | (B-45) | - | α-NPD | (K-3) |
| Comparative Example 4 | (B-7) | - | TCTA | (K-10) |
| Comparative Example 5 | (C-15) | - | TCTA | (K-10) |
| Comparative Example 6 | BCP | Li | α-NPD | (K-3) |
| Comparative Example 7 | BCP | Li | TCTA | (K-10) |
| Comparative Example 8 | BCP | Cs | α-NPD | (K-3) |

**Table 1 - 2**

| | Voltage | Luminance | Current efficiency | Color of emitted light | Half lifetime |
|---|---|---|---|---|---|
| | (V) | (cd/m²) | (cd/A) | | (hours) |
| Example 1 | 7.8 | 102 | 7.67 | bluish green | 350 |
| Example 2 | 7.5 | 130 | 10.2 | bluish green | 720 |
| Example 3 | 6.5 | 101 | 10.8 | bluish green | 680 |
| Example 4 | 8.8 | 111 | 7.26 | bluish green | 420 |
| Example 5 | 10.2 | 103 | 10.3 | bluish green | 450 |
| Example 6 | 9.2 | 102 | 11.4 | bluish green | 380 |
| Example 7 | 8.3 | 98 | 11.7 | bluish green | 370 |
| Example 8 | 10.8 | 104 | 12.4 | bluish green | 460 |
| Example 9 | 10.0 | 110 | 12.8 | bluish green | 520 |
| Example 10 | 8.2 | 102 | 14.6 | bluish green | 440 |
| Comparative Example 1 | 8.3 | 100 | 6.42 | bluish green | 120 |
| Comparative Example 2 | 12.4 | 103 | 7.02 | bluish green | 100 |
| Comparative Example 3 | 8.1 | 100 | 7.10 | bluish green | 160 |
| Comparative Example 4 | 12.0 | 102 | 7.38 | bluish green | 180 |
| Comparative Example 5 | 10.1 | 98 | 8.38 | bluish green | 170 |
| Comparative Example 6 | 7.8 | 75 | 4.24 | bluish green | 230 |
| Comparative Example 7 | 11.4 | 101 | 6.22 | bluish green | 220 |
| Comparative Example 8 | 8.2 | 88 | 4.82 | bluish green | 160 |

As shown in Table 1, in Comparative Examples 1 to 5 in which no reductive dopants were added, the efficiency of light emission was markedly inferior and the life was shorter in comparison with those in Examples 1 to 10. In Comparative Examples 6 and 8, the luminance of emitted light and the efficiency of light emission were markedly inferior and the life was shorter although the voltage was low. In Comparative Example 7, the voltage was high, the efficiency of light emission was inferior, and the life was short.

### INDUSTRIAL APPLICABILITY

As specifically described above, the organic electroluminescence device of the present invention exhibits a great efficiency of light emission and has a long life due to the use of the phosphorescent light emission since the electron transporting ability of the electron transporting layer is improved. The organic electroluminescence device of the present invention is advantageously used as the organic electroluminescence device for full color applications.

## Claims

1. An organic electroluminescence device comprising a cathode, an anode and an organic thin film layer which is sandwiched between the cathode and the anode and comprises at least one layer containing a light emitting layer comprising a phosphorescent light emitting compound, wherein the organic electroluminescence device further comprises an electron injecting layer which is adhered to the cathode and comprises at least one compound selected from metal chelate complexes with a ring having nitrogen atom, five-membered cyclic derivatives having nitrogen atom, non-condensed six-membered cyclic derivatives having nitrogen atom and condensed six-membered cyclic derivatives having nitrogen atom and one condensed carbon ring as a main component and at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds as a reductive dopant.

2. An electroluminescence device according to Claim 1, wherein the metal chelate complex with a ring having nitrogen atom is a compound represented by following general formula (1): 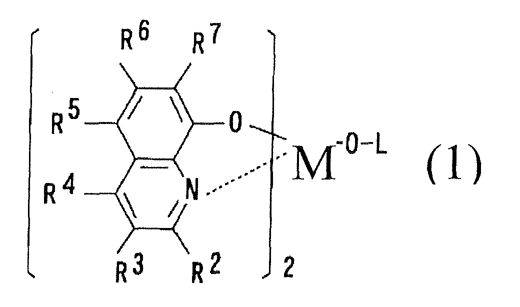 wherein R² to R⁷ each independently represent hydrogen atom, a halogen atom, an oxy group, an amino group or a hydrocarbon group having 1 to 40 carbon atoms, each of which may be substituted,
M represents aluminum, gallium or indium, and
L represents a group represented by following general formula (2) or (3): 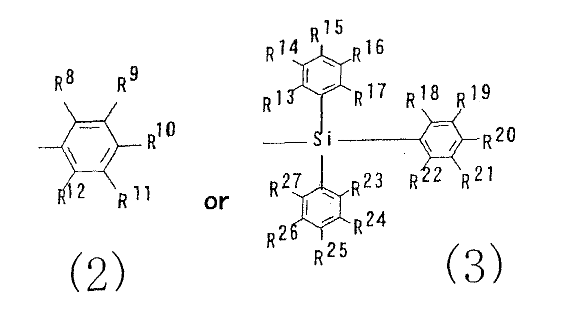 wherein R⁸ to R¹² each independently represent hydrogen atom or a substituted or unsubstituted hydrocarbon group having 1 to 40 carbon atoms, adjacent groups represented by R⁸ to R¹² may be bonded to each other to form a cyclic structure, R¹³ to R²⁷ each independently represent hydrogen atom or a substituted or unsubstituted hydrocarbon group having 1 to 40 carbon atoms, and adjacent groups represented by R¹³ to R²⁷ may be bonded to each other to form a cyclic structure.

3. An electroluminescence device according to Claim 1, wherein a five-membered ring having nitrogen atom in the five-membered cyclic derivatives having nitrogen atom is imidazole ring, triazole ring, tetrazole ring, thiadiazole ring, oxatriazole ring or thiatriazole ring.

4. An electroluminescence device according to Claim 3, wherein the imidazole ring is benzimidazole ring, pyrimidinoimidazole ring, pyridinoimidazole ring or pyridazinoimidazole ring.

5. An electroluminescence device according to Claim 1, wherein a non-condensed six-membered ring having nitrogen atom in the non-condensed six-membered cyclic derivatives having nitrogen atom is pyridine, pyrazine or pyrimidine.

6. An electroluminescence device according to Claim 1, wherein a condensed six-membered ring having nitrogen atom in the condensed six-membered cyclic derivatives having nitrogen atom and one condensed carbon ring is quinoxaline, quinoline, isoquinoline or benzopyrimidine.

7. An electroluminescence device according to Claim 6, wherein the condensed six-membered ring in the condensed six-membered cyclic derivatives having nitrogen atom and one condensed carbon ring is triphenylquinoxaline, triphenylquinoline, triphenylbenzo- pyrimidine or those derived from a dimer or a trimer of these rings.

8. An electroluminescence device according to Claim 1, wherein the reductive dopant is added into an interfacial region between the electron injecting layer and the cathode in a form of a layer or islands.

9. An electroluminescence device according to Claim 1, wherein the light emitting layer comprises a host material and a phosphorescent metal complex.

10. An electroluminescence device according to Claim 9, wherein the phosphorescent metal complex is an iridium complex, an osmium complex or a platinum complex.
